# EUROPÄISCHE PATENTSCHRIFT

(11) **EP 3 110 748 B1**
(45) Veröffentlichungstag und Bekanntmachung des Hinweises auf die Patenterteilung: **10.01.2018**
(21) Anmeldenummer: 15704464.5
(22) Anmeldetag: 11.02.2015
(51) Int. Cl.: B81C 1/00

(54) **VERFAHREN ZUR HERSTELLUNG EINES BAUTEILS UND BAUTEIL**
METHOD FOR PRODUCING A COMPONENT, AND COMPONENT
PROCÉDÉ DE PRODUCTION D'UNE PIÈCE ET PIÈCE

(30) Priorität: 25.02.2014 DE 102014002825
(43) Veröffentlichungstag der Anmeldung: 04.01.2017
(73) Patentinhaber: Northrop Grumman LITEF GmbH, 79115 Freiburg (DE)
(72) Erfinder: GEIGER, Wolfram, 79285 Ebringen (DE)
(74) Vertreter: Müller Hoffmann & Partner
(86) Internationale Anmeldenummer: PCT/EP2015/000304
(87) Internationale Veröffentlichungsnummer: WO 2015/128063

(56) Entgegenhaltungen:
- DE-A1-102010 001 824
- US-A1- 2013 099 382

## Beschreibung

Die Erfindung bezieht sich auf ein Verfahren zur Herstellung eines Bauteils, insbesondere eines mikromechanischen, mikro-elektromechanischen (MEMS) bzw. mikro-opto-elektromechanischen (MOEMS) Bauteils, sowie auf ein derartiges Bauteil.

Um Umwelteinflüsse wie Feuchtigkeit und Verunreinigungen (z.B. Staub) auf mikro-elektromechanische Bauteile (MEMS) bzw. mikro-opto-elektromechanische Bauteile (MOEMS) möglichst gering zu halten, werden aktive Strukturen derartiger Bauteile häufig hermetisch abgekapselt. Unter "aktiver Struktur" sind hier insbesondere bewegliche Strukturen, optische Strukturen oder Strukturen, die gleichermaßen bewegliche und optische Komponenten aufweisen (z.B. bewegliche Spiegel) zu verstehen. Der Begriff "aktives Gebiet" bezeichnet das Gebiet bzw. Volumen des Bauteils, in dem die aktive Struktur liegt bzw. sich bewegt. Die hermetisch dichte Verkapselung kann weiterhin zur Einstellung eines bestimmten Innendrucks im Bereich der aktiven Strukturen genutzt werden, was insbesondere bei Bauteilen, deren Funktionsweise von einem definierten Innendruck abhängt, wie z.B. Beschleunigungssensoren und Gyroskopen (Drehraten-Sensoren), vorteilhaft ist.

Damit möglichst kostengünstig produziert werden kann, erfolgt die Fertigung von MEMS- bzw. MOEMS-Bauteilen in der Regel auf Wafer-Ebene. Die dabei häufig durchzuführenden Fügeprozesse können beispielsweise auf Basis von Direktbondprozessen sowie anodischen Bondprozessen erfolgen.

Die Herausführung elektrischer Kontakte aus dem hermetisch dichten Bereich des Bauteils zur Kontaktierung von bestimmten Teilen des Bauteils (z.B. zur Kontaktierung der aktiven Struktur) ist fertigungstechnisch schwierig zu realisieren. Es kommen verschiedene Möglichkeiten in Betracht: Die elektrischen Kontakte können beispielsweise durch lateral verlaufende, mittels Implantations- bzw. Diffusionsverfahren hergestellte Halbleiterschichten mit niedrigem Schichtwiderstand realisiert werden. Weiterhin ist eine Realisierung durch strukturierte, mit einer planarisierten Passivierungsschicht bedeckte leitfähige Schichten möglich.

Alternativ können die elektrischen Kontakte in Form mehrerer vertikal verlaufender Durchkontaktierungen aus dem Bauteil herausgeführt werden. Dabei können die Kontakte jeweils durch einen Draht, der durch einen Durchbruch oder ein Loch in einer Abdeckung des Bauteils hindurchgeführt und mit dem zu kontaktierenden Teil des Bauteils verbunden wird, hergestellt werden. Dabei kann es jedoch bei großen Aspektverhältnissen des Durchbruchs, d.h. bei großen Verhältnissen der Tiefe des Durchbruchs zur lateralen Fläche des Durchbruchs, zu Schwierigkeiten hinsichtlich der Realisierung und der Haltbarkeit des Kontaktes kommen. Entsprechend einer anderen Möglichkeit kann ein Kontakt in einem Durchbruch oder einem Loch in einer Abdeckung des Bauteils durch die Abscheidung einer elektrisch leitfähigen Schicht oder eines den Durchbruch füllenden elektrisch leitenden Materials erzeugt werden. Dies kann, insbesondere bei großen Aspektverhältnissen des Durchbruchs zu Schwierigkeiten bei der Realisierung des Kontaktes, beispielsweise durch Löcher in der Füllung oder nicht durchgängig abgeschiedene Schichten, führen sowie einen großen Materialaufwand bezüglich des aufzufüllenden Materials oder zusätzliche Prozessierungsschritte erfordern.

Ein weiteres Problem kann beim Prozess des Verbindens der Abdeckung des Bauteils mit den anderen Schichten des Bauteils entstehen. Sind die oben erwähnten Durchbrüche bereits vor dem Fügeprozess vorhanden und nicht mit einem leitfähigen Material gefüllt, so verringert sich die Fügefläche, die für das Verbinden der Abdeckung mit den anderen Schichten zur Verfügung steht. Sind vorhandene Durchbrüche bereits mit leitfähigem Material gefüllt, so können daraus Einschränkungen bei den Parametern des Fügeprozesses (beispielsweise Temperatur und Druck) folgen. In beiden Fällen kann die Qualität der Verbindung sinken und die Herstellung des hermetisch dichten Bereiches des Bauteils nicht gewährleistet sein.

Es ist daher die Aufgabe der Erfindung, ein Verfahren zum Herstellen eines Bauteils, insbesondere eines mikromechanischen, mikro-elektromechanischen oder mikro-opto-elektromechanischen Bauteils, sowie ein solches Bauteil bereitzustellen, mit dem ein elektrischer Kontakt zu Teilen des Bauteils realisiert werden kann.

Die Aufgabe wird gelöst durch die Gegenstände der unabhängigen Patentansprüche. Bevorzugte Ausführungsformen finden sich in den Unteransprüchen.

Ein Verfahren zum Herstellen eines Bauteils gemäß der vorliegenden Erfindung umfasst das Erzeugen eines ersten Schichtverbundes, der ein erstes Substrat aus einem elektrisch leitenden Material und mindestens einen mit einem isolierenden Material gefüllten Graben umfasst. Der mindestens eine Graben erstreckt sich von einer ersten Oberfläche des ersten Substrates aus und ist derart angeordnet, dass ein erster Bereich des ersten Substrates durch den mindestens einen Graben an der ersten Oberfläche lateral von anderen Bereichen des ersten Substrates elektrisch isoliert ist. Weiterhin umfasst das Verfahren zum Herstellen eines Bauteils das Erzeugen eines zweiten Schichtverbundes, der den ersten Schichtverbund und eine Strukturschicht umfasst. Die Strukturschicht umfasst eine aktive Struktur des Bauteils und ist mindestens in einem ersten Bereich elektrisch leitfähig. Der erste Bereich der Strukturschicht grenzt in dem ersten Bereich des ersten Substrates an die erste Oberfläche des ersten Substrates und ist mit dem ersten Bereich des ersten Substrates elektrisch leitend verbunden. Weiterhin umfasst das Verfahren zum Herstellen eines Bauteils das Erzeugen einer ersten elektrisch leitenden Kontaktfläche auf einer zweiten Oberfläche des ersten Substrates, wobei die zweite Oberfläche der ersten Oberfläche gegenüber liegt und wobei die erste Kontaktfläche in dem ersten Bereich des ersten Substrates angeordnet ist. Der erste Bereich des ersten Substrates ist an der zweiten Oberfläche des ersten Substrates durch den mindestens einen Graben lateral von anderen Bereichen des ersten Substrates elektrisch isoliert. Damit ist eine elektrische Verbindung zwischen der ersten Kontaktfläche auf der zweiten Oberfläche des ersten Substrates und dem ersten Bereich der Strukturschicht mittels des ersten Bereiches des ersten Substrates realisiert.

Gemäß einer Ausführungsform des Verfahrens zum Herstellen eines Bauteils kann beim Erzeugen des ersten Schichtverbundes eine erste Vertiefung in der ersten Oberfläche des ersten Substrates erzeugt werden, wobei die Tiefe der ersten Vertiefung kleiner als die Dicke des ersten Substrates ist. Der erste Bereich des ersten Substrates ist außerhalb der ersten Vertiefung angeordnet. Innerhalb der ersten Vertiefung kann ein zweiter Bereich des ersten Substrates angeordnet sein, der durch den mindestens einen Graben an der ersten Oberfläche des ersten Substrates lateral von anderen Bereichen des ersten Substrates elektrisch isoliert ist. Beim Erzeugen des zweiten Schichtverbundes wird mindestens ein Teil der aktiven Struktur innerhalb der ersten Vertiefung mit einem Abstand zum ersten Substrat angeordnet. Weiterhin wird eine zweite elektrisch leitende Kontaktfläche auf der zweiten Oberfläche des ersten Substrates erzeugt, wobei die zweite Kontaktfläche im zweiten Bereich des ersten Substrates angeordnet ist und wobei der zweite Bereich des ersten Substrates durch den mindestens einen Graben an der zweiten Oberfläche des ersten Substrates lateral von anderen Bereichen des ersten Substrates elektrisch isoliert ist.

Gemäß einer Ausführungsform umfasst der erste Schichtverbund mindestens zwei mit isolierendem Material gefüllte Gräben, und mindestens zwei zweite Bereiche des ersten Substrates sind innerhalb der ersten Vertiefung angeordnet. Mindestens zwei zweite Kontaktflächen werden auf der zweiten Oberfläche des ersten Substrates erzeugt, wobei jede zweite Kontaktfläche in einem der zweiten Bereiche des ersten Substrates angeordnet ist.

Gemäß einer Ausführungsform kann der erste Schichtverbund nur das erste Substrat und den mindestens einen Graben umfassen, wobei sich der mindestens eine Graben im ersten Substrat vor dem Erzeugen des zweiten Schichtverbundes bis zur zweiten Oberfläche des ersten Substrates erstreckt.

Gemäß einer anderen Ausführungsform erstreckt sich der mindestens eine Graben im ersten Schichtverbund vor dem Erzeugen des zweiten Schichtverbundes zunächst bis zu einer Tiefe, die kleiner als die Dicke des ersten Schichtverbundes ist. Nach dem Erzeugen des zweiten Schichtverbundes und vor dem Erzeugen der ersten Kontaktfläche wird die Dicke des ersten Schichtverbundes von einer ersten Oberfläche des ersten Schichtverbundes aus bis zur Tiefe des mindestens einen Grabens reduziert. Die erste Oberfläche des ersten Schichtverbundes ist dabei die Oberfläche des ersten Schichtverbundes, die der ersten Oberfläche des ersten Substrates gegenüberliegt.

Gemäß einer weiteren Ausführungsform kann der zweite Schichtverbund weiterhin einen dritten Schichtverbund umfassen, der auf der dem ersten Schichtverbund gegenüberliegenden Seite an die Substratschicht angrenzt und ein zweites Substrat umfasst.

Umfasst der zweite Schichtverbund einen dritten Schichtverbund, so kann der zweite Schichtverbund gemäß einer ersten Ausführungsform dadurch erzeugt werden, dass zunächst die Strukturschicht auf der ersten Oberfläche des ersten Substrates aufgebracht wird und danach die auf dem ersten Schichtverbund aufgebrachte Strukturschicht mit dem dritten Schichtverbund verbunden wird. Gemäß einer anderen Ausführungsform kann der zweite Schichtverbund dadurch erzeugt werden, dass zunächst die Strukturschicht auf dem dritten Schichtverbund aufgebracht wird und nachfolgend die auf dem dritten Schichtverbund aufgebrachte Strukturschicht mit dem ersten Schichtverbund verbunden wird.

Gemäß einer Ausführungsform kann der dritte Schichtverbund eine mindestens in einem Bereich leitfähige Deckschicht umfassen, die auf einer ersten Oberfläche des zweiten Substrates angeordnet ist. Die erste Oberfläche des zweiten Substrates ist die der Strukturschicht zugewandte Oberfläche des zweiten Substrates. In einer ersten Oberfläche der Deckschicht kann eine zweite Vertiefung erzeugt werden, wobei die erste Oberfläche der Deckschicht die der Strukturschicht zugewandte Oberfläche der Deckschicht ist. Die Tiefe der zweiten Vertiefung ist dabei kleiner als die Dicke der Deckschicht. Beim Erzeugen des zweiten Schichtverbundes wird der leitfähige Bereich der Deckschicht an den ersten Bereich der Strukturschicht und an einen zweiten Bereich der Strukturschicht angrenzend angeordnet. Dabei ist der erste Bereich der Strukturschicht außerhalb der aktiven Struktur angeordnet, während der zweite Bereich der Strukturschicht innerhalb der aktiven Struktur angeordnet und elektrisch leitfähig ist. Die zweite Vertiefung und mindestens ein Teil der aktiven Struktur werden so angeordnet, dass die laterale Position der zweiten Vertiefung der lateralen Position des mindestens einen Teils der aktiven Struktur entspricht. Dadurch bildet die Deckschicht eine Leiterbahnbrücke, die den zweiten Bereich der Strukturschicht mit dem ersten Bereich der Strukturschicht verbindet.

Gemäß einer Ausführungsform können die Strukturschicht und die der Strukturschicht zugewandte Schicht des dritten Schichtverbundes aus demselben Material bestehen.

Gemäß einer weiteren Ausführungsform können das erste Substrat und die Strukturschicht aus demselben Material bestehen.

Für den Fall, dass die beim Erzeugen des zweiten Schichtverbundes miteinander zu verbindenden Schichten, das heißt das erste Substrat und die Strukturschicht und gegebenenfalls die der Strukturschicht zugewandte Schicht des dritten Schichtverbundes, aus demselben Material bestehen, können besonders geeignete Verfahren zum Verbinden dieser Schichten, zum Beispiel Bondprozesse, genutzt werden. Beispielsweise können die Schichten aus einem Halbleitermaterial, insbesondere Silizium, bestehen.

Ein Bauteil gemäß der vorliegenden Erfindung umfasst einen ersten Schichtverbund, der ein erstes Substrat aus einem elektrisch leitenden Material und mindestens einen mit einem isolierenden Material gefüllten Graben umfasst. Der mindestens eine Graben erstreckt sich von einer ersten Oberfläche des ersten Substrates aus bis zu einer zweiten Oberfläche des ersten Substrates, wobei die zweite Oberfläche des ersten Substrates der ersten Oberfläche des ersten Substrates gegenüberliegt. Der mindestens eine Graben ist derart angeordnet, dass ein erster Bereich des ersten Substrates durch den mindestens einen Graben lateral von anderen Bereichen des ersten Substrates elektrisch isoliert ist. Das Bauteil umfasst weiterhin eine Strukturschicht, die eine aktive Struktur des Bauteils umfasst und die mindestens in einem ersten Bereich elektrisch leitfähig ist. Der erste Bereich der Strukturschicht grenzt in dem ersten Bereich des ersten Substrates an die erste Oberfläche des ersten Substrates, wobei der erste Bereich der Strukturschicht elektrisch leitend mit dem ersten Bereich des ersten Substrates verbunden ist. Das Bauteil umfasst weiterhin eine erste elektrisch leitende Kontaktfläche auf der zweiten Oberfläche des ersten Substrates, wobei die erste Kontaktfläche in dem ersten Bereich des ersten Substrates angeordnet ist.

Gemäß einer Ausführungsform ist in der ersten Oberfläche des ersten Substrates eine erste Vertiefung ausgebildet, die eine Tiefe kleiner als die Dicke des ersten Substrates aufweist. Der erste Bereich des ersten Substrates ist dabei außerhalb der ersten Vertiefung angeordnet, während ein zweiter Bereich des ersten Substrates innerhalb der ersten Vertiefung angeordnet sein kann, wobei der zweite Bereich des ersten Substrates durch den mindestens einen Graben lateral von anderen Bereichen des ersten Substrates elektrisch isoliert ist. Mindestens ein Teil der aktiven Struktur ist innerhalb der ersten Vertiefung mit einem Abstand zum ersten Substrat angeordnet. Das Bauteil umfasst weiterhin eine zweite elektrisch leitende Kontaktfläche auf der zweiten Oberfläche des ersten Substrates, wobei die zweite Kontaktfläche im zweiten Bereich des ersten Substrates angeordnet ist.

Gemäß einer Ausführungsform umfasst der erste Schichtverbund mindestens zwei mit isolierendem Material gefüllte Gräben. Mindestens zwei zweite Bereiche des ersten Substrates sind innerhalb der ersten Vertiefung angeordnet und mindestens zwei zweite Kontaktflächen sind auf der zweiten Oberfläche des ersten Substrates angeordnet, wobei jede zweite Kontaktfläche in einem der zweiten Bereiche des ersten Substrates angeordnet ist.

Gemäß einer Ausführungsform kann das Bauteil weiterhin einen dritten Schichtverbund umfassen, der auf der dem ersten Schichtverbund gegenüberliegenden Seite an die Strukturschicht angrenzt und ein zweites Substrat umfasst. Der erste Schichtverbund, die Strukturschicht und der dritte Schichtverbund können so miteinander verbunden sein, dass die aktive Struktur der Strukturschicht hermetisch dicht abgeschlossen ist.

Gemäß einer Ausführungsform kann der dritte Schichtverbund eine mindestens in einem Bereich leitfähige Deckschicht umfassen. Die Deckschicht ist auf einer ersten Oberfläche des zweiten Substrates angeordnet, wobei die erste Oberfläche des zweiten Substrates die der Strukturschicht zugewandte Oberfläche des zweiten Substrates ist. Weiterhin kann in der ersten Oberfläche der Deckschicht eine zweite Vertiefung ausgebildet sein, wobei die erste Oberfläche der Deckschicht die der Strukturschicht zugewandte Oberfläche der Deckschicht ist und wobei die Tiefe der zweiten Vertiefung kleiner als die Dicke der Deckschicht ist. Der leitfähige Bereich der Deckschicht grenzt an den ersten Bereich der Strukturschicht und an einen zweiten Bereich der Strukturschicht an, wobei der erste Bereich der Strukturschicht außerhalb der aktiven Struktur angeordnet ist und der zweite Bereich der Strukturschicht innerhalb der aktiven Struktur angeordnet und elektrisch leitfähig ist. Die erste Vertiefung und mindestens ein Teil der aktiven Struktur sind so angeordnet, dass die laterale Position der zweiten Vertiefung der lateralen Position des mindestens einen Teils der aktiven Struktur entspricht. Die Deckschicht bildet damit eine Leiterbahnbrücke, die den zweiten Bereich der Strukturschicht mit dem ersten Bereich der Strukturschicht verbindet.

Gemäß einer Ausführungsform können die Strukturschicht und die der Strukturschicht zugewandte Schicht des dritten Schichtverbundes aus demselben Material bestehen.

Gemäß einer weiteren Ausführungsform können das erste Substrat und die Strukturschicht aus demselben Material bestehen.

Ausführungsformen der vorliegenden Erfindung werden im Folgenden anhand der Figuren näher erläutert, wobei gleichartige Elemente mit gleichen Bezugszeichen gekennzeichnet sind.

Die Figur 1A zeigt eine schematische Darstellung eines Bauteils gemäß einer Ausführungsform der Erfindung in einem Querschnitt entlang einer Linie I-I' der Fig. 1B.

Die Figur 1B zeigt eine schematische Darstellung zweier Schichten des Bauteils gemäß einer Ausführungsform der Erfindung in der Draufsicht.

Die Figur 2 zeigt eine schematische Darstellung eines Bauteils gemäß einer weiteren Ausführungsform der Erfindung in einem Querschnitt entlang einer Linie I-I'.

Die Figuren 3A bis 3C zeigen Schritte einer ersten Ausführungsform des erfindungsgemäßen Verfahrens anhand von Querschnitten.

Die Figuren 4A bis 4D zeigen Schritte einer zweiten Ausführungsform des erfindungsgemäßen Verfahrens anhand von Querschnitten.

Die Figuren 5A bis 5C zeigen Schritte einer dritten Ausführungsform des erfindungsgemäßen Verfahrens anhand von Querschnitten.

Die Figuren 6A bis 6D zeigen Schritte einer vierten Ausführungsform des erfindungsgemäßen Verfahrens anhand von Querschnitten.

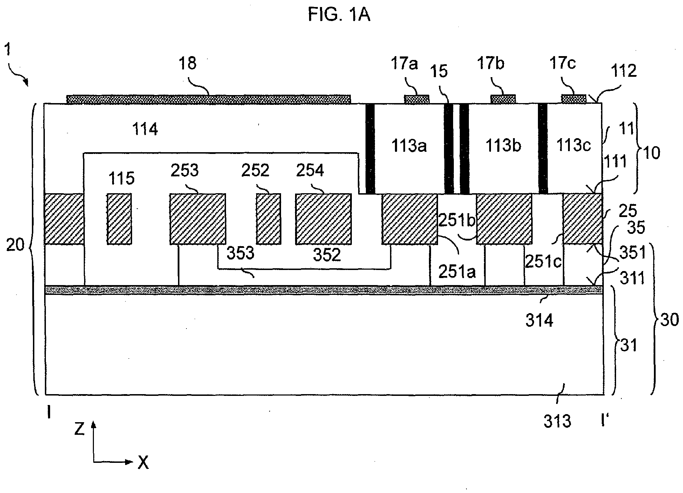

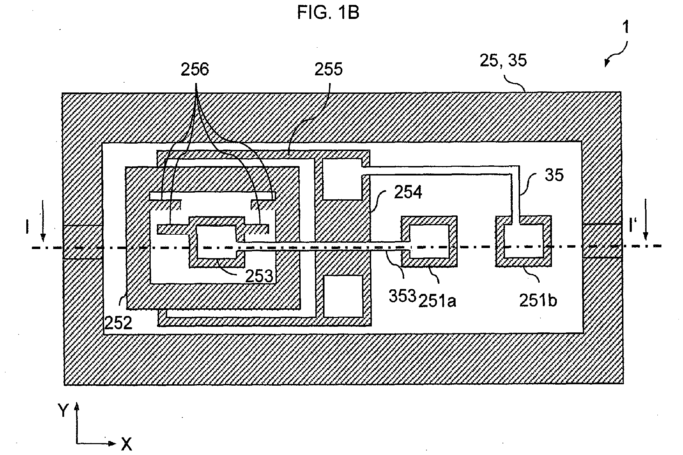

Die Figur 1A zeigt einen Querschnitt durch ein erfindungsgemäßes Bauteil gemäß einer ersten Ausführungsform entlang einer Linie I-I', während Figur 1B eine Draufsicht auf zwei Schichten des Bauteiles zeigt. Das in der Figur 1A dargestellte Bauteil 1 umfasst einen ersten Schichtverbund 10, eine Strukturschicht 25, einen dritten Schichtverbund 30 sowie erste Kontaktflächen 17a bis 17c und eine zweite Kontaktfläche 18. Der erste Schichtverbund 10, die Strukturschicht 25 und der dritte Schichtverbund 30 bilden zusammen den zweiten Schichtverbund 20.

Der erste Schichtverbund 10 umfasst ein erstes Substrat 11 mit einer ersten Oberfläche 111 und einer zweiten Oberfläche 112, die der ersten Oberfläche 111 des ersten Substrates 11 gegenüberliegt. Der Begriff "Substrat" beschreibt hierbei Gebilde, die nur aus einem Material bestehen, beispielsweise einen Siliziumwafer, die aber auch einen Verbund aus mehreren Schichten und Materialien beinhalten können, solange das erste Substrat 11 elektrisch leitfähig ist.

Das erste Substrat 11 weist mindestens einen ersten Bereich 113 auf, der von anderen Bereichen des ersten Substrates 11 durch einen Graben 15 elektrisch isoliert ist. In Figur 1A sind drei erste Bereiche 113a, 113b und 113c dargestellt. Zwischen spezifischen Gräben 15, die verschiedene erste Bereiche 113 elektrisch isolieren, können weitere Bereiche des ersten Substrates 11 angeordnet sein. Dies ist in Figur 1A für die ersten Bereiche 113a und 113b dargestellt. Jedoch kann ein und derselbe Graben 15 auch an zwei erste Bereiche angrenzen, wie dies in Figur 1A für die ersten Bereiche 113b und 113c dargestellt ist. Die Gräben 15 sind mit isolierendem Material gefüllt und erstrecken sich von der ersten Oberfläche 111 des ersten Substrates 11 bis zur zweiten Oberfläche 112 des ersten Substrates 11. Die Gräben 15 sind derart angeordnet, dass ein Graben 15 jeweils einen ersten Bereich 113 vollständig von anderen Bereichen des ersten Substrates 11 isoliert. In der Draufsicht können die Gräben 15 beliebig angeordnet sein, solange jeder spezifische Graben 15 einen spezifischen ersten Bereich 113 vollständig isoliert. Der von einem spezifischen Graben 15 isolierte spezifische erste Bereich 113 kann eine beliebige Form in der Draufsicht aufweisen. Der isolierte erste Bereich 113 kann beispielsweise eine runde Form, eine rechteckige Form, eine hexagonale Form oder jede beliebige andere Form in der Draufsicht aufweisen. Die Gräben 15 können sich im Querschnitt beliebig von der ersten Oberfläche 111 zur zweiten Oberfläche 112 erstrecken. Das heißt, die Gräben 15 können senkrecht zu den Oberflächen 111 und 112 oder in definierten Winkeln zu diesen Oberflächen, geradlinig oder gekrümmt verlaufen, solange sie sich durchgehend erstrecken.

Im ersten Substrat 11 kann eine erste Vertiefung 115 ausgebildet sein, die sich von der ersten Oberfläche 111 aus erstreckt, wobei die Tiefe der ersten Vertiefung 115 kleiner als die Dicke des ersten Substrates 11 ist. Innerhalb der ersten Vertiefung 115 ist ein zweiter Bereich 114 des ersten Substrates 11 ausgebildet, der durch mindestens einen der Gräben 15 lateral von anderen Bereichen des ersten Substrates 11 elektrisch isoliert ist. Dabei kann der zweite Bereich 114 des ersten Substrates 11 sich lateral auch über die erste Vertiefung 115 hinaus erstrecken. Das heißt, dass der zweite Bereich 114 sowohl physisch als auch elektrisch mit Bereichen des ersten Substrates 11 außerhalb der ersten Vertiefung 115 verbunden sein kann. In dem in Figur 1A und 1B dargestellten Fall ist der zweite Bereich 114 von den ersten Bereichen 113a bis 113c elektrisch isoliert.

Die Strukturschicht 25 umfasst erste Bereiche 251a bis 251c, eine aktive Struktur 252, einen zweiten Bereich 253 und einen dritten Bereich 254. Die ersten Bereiche 251a bis 251c sind außerhalb der aktiven Struktur 252 angeordnet, währende der zweite Bereich 253 innerhalb der aktiven Struktur 252 angeordnet ist. Die Ausgestaltung der Strukturschicht soll anhand der Figur 1B näher erläutert werden.

Figur 1B zeigt die Strukturschicht 25 eines mikromechanischen Bauteiles 1, das eine aktive Struktur 252 aufweist, in einer beispielhaften Ausführungsform. Die aktive Struktur 252 ist mittels einer Feder 255 mit dem dritten Bereich 254 der Strukturschicht verbunden und kann sich im Rahmen der Beweglichkeit der Feder 255 in alle Richtungen bewegen. Die ersten Bereiche 251a bis 251c, sowie der zweite Bereich 253 und der dritte Bereich 254 der Strukturschicht 25 sind fest mit anderen Schichten des Bauteils 1 verbunden und können sich nicht bewegen. Die aktive Struktur 252 bildet einen geschlossenen Rahmen, innerhalb dessen der zweite Bereich 253 der Strukturschicht angeordnet ist. Über Elektroden 256, die an der aktiven Struktur 252 und dem zweiten Bereich 253 angebracht sind, kann die Bewegung der aktiven Struktur detektiert werden. Die Strukturschicht 25 kann aus einem leitfähigen Material bestehen, zum Beispiel aus dotiertem Silizium oder einem anderen Halbleiter-Material. In diesem Falle sind die einzelnen Bereiche der Strukturschicht 25 physisch voneinander getrennt. Die Strukturschicht 25 kann aber auch aus einem Material bestehen, das nur in bestimmten Bereichen elektrisch leitfähig ist. Diese Bereiche können beispielsweise dotierte Halbleiter-Bereiche sein, die voneinander durch undotierte Halbleiterbereiche oder isolierende Bereiche elektrisch isoliert sind. Dann können einzelne Bereiche der Strukturschicht 25 auch physisch miteinander verbunden sein.

Figur 1B zeigt weiterhin eine Deckschicht 35, die später näher erläutert wird.

Wie Figur 1A zu entnehmen ist, grenzen die ersten Bereiche 251a bis 251c der Strukturschicht 25 an die erste Oberfläche 111 des ersten Substrates 11 in den ersten Bereichen 113 des ersten Substrates 11. Die ersten Bereiche 251a bis 251c der Strukturschicht 25 sind damit elektrisch leitend mit den ersten Bereichen 113 des ersten Substrates 11 verbunden. Die aktive Struktur 252 ist innerhalb der ersten Vertiefung 115 des ersten Substrates 11 mit einem Abstand zum ersten Substrat 11 angeordnet. Sie kann sich damit frei in eine Richtung senkrecht zur ersten Oberfläche 111 des ersten Substrates 11, das heißt in z-Richtung, bewegen.

Das Bauteil 1 weist weiterhin einen dritten Schichtverbund 30 auf. Der dritte Schichtverbund 30 kann ein zweites Substrat 31 umfassen. Auch hier beschreibt der Begriff "Substrat" Gebilde, die nur aus einem Material bestehen, beispielsweise einen Siliziumwafer oder eine Glasscheibe, die aber auch einen Verbund aus mehreren Schichten und Materialien beinhalten können. In Figur 1A ist ein zweites Substrat 31, das eine erste Schicht 313 und eine zweite Schicht 314 umfasst, dargestellt. Dabei können sich die Schichten im Material und in ihrer Leitfähigkeit voneinander unterscheiden. Beispielsweise kann die erste Schicht 313 aus einem zumindest teilweise elektrisch leitfähigen Material, beispielsweise Silizium, bestehen, während die zweite Schicht 314 zum Beispiel eine Schicht aus einem isolierenden Material, beispielsweise Siliziumoxid, sein kann. Jedoch kann auch beispielsweise die erste Schicht 313 aus einem isolierenden Material sein, und die zweite Schicht 314 eine Schicht sein, die nur in bestimmten Bereichen leitfähig ist, oder die zweite Schicht 314 kann auch gar nicht vorhanden sein. Das zweite Substrat 31 kann auch nur aus einem oder mehreren elektrisch isolierenden Materialien bestehen.

Der dritte Schichtverbund 30 kann weiterhin eine Deckschicht 35 umfassen, die auf einer ersten Oberfläche 311 des zweiten Substrates 31 angeordnet ist. Die erste Oberfläche 311 des zweiten Substrates 31 ist die Oberfläche des zweiten Substrates 31, die der Strukturschicht 25 zugewandt ist. Die Deckschicht 35 kann aus einem mindestens in einem Bereich elektrisch leitfähigen Material bestehen und kann zur elektrischen Verbindung zwischen verschiedenen Bereichen der Strukturschicht 25 dienen. Die Deckschicht 35 kann damit aus einer strukturierten Schicht aus einem elektrisch leitfähigen Material bestehen, wobei einzelne Bereiche der Deckschicht 35 physisch voneinander getrennt sind. Jedoch können auch nur einzelne elektrisch leitfähige Bereiche in der Deckschicht 35 ausgebildet sein, die nicht notwendigerweise physisch voneinander getrennt sein müssen. Die Deckschicht 35 kann beispielsweise aus einem Halbleiter-Material, insbesondere aus Silizium, bestehen. Eine erste Oberfläche 351 der Deckschicht 35 grenzt zumindest in spezifischen Bereichen an die Strukturschicht 25 an. Beispielsweise grenzt die Oberfläche 351 der Deckschicht 35 an die ersten Bereiche 251a bis 251c und den zweiten Bereich 253 der Strukturschicht 25 an. Die Deckschicht 35 kann eine zweite Vertiefung 352 aufweisen, die sich von der ersten Oberfläche 351 der Deckschicht 35 aus erstreckt und eine Tiefe aufweist, die kleiner als die Dicke der Deckschicht 35 ist. Mit Hilfe der in der ersten Vertiefung 352 abgedünnten Deckschicht 35 kann somit eine Leiterbahnbrücke 353 realisiert werden, die beispielsweise den ersten Bereich 251a der Strukturschicht 25 mit dem zweiten Bereich 253 der Strukturschicht 25 elektrisch leitend verbindet, wobei die aktive Struktur 252 der Strukturschicht 25 überbrückt wird.

Der erste Schichtverbund 10, die Strukturschicht 25 und der dritte Schichtverbund 30 bilden zusammen den zweiten Schichtverbund 20, wobei einzelne Teile des dritten Schichtverbundes 30 oder der gesamte Schichtverbund 30 optional sind. Ist der dritte Schichtverbund 30 vorhanden, so kann die aktive Struktur 252 hermetisch dicht durch die Verbindung des ersten Schichtverbundes 10, der Strukturschicht 25 und des dritten Schichtverbundes 30 abgekapselt werden.

Das Bauteil 1 umfasst weiterhin erste Kontaktflächen 17a bis 17c sowie eine zweite Kontaktfläche 18. Die Kontaktflächen 17a bis 17c und 18 sind aus einem leitfähigen Material, beispielsweise Metall, und sind auf der zweiten Oberfläche 112 des ersten Substrates 11 angeordnet. Dabei ist jede erste Kontaktfläche 17a bis 17c in einem ersten Bereich 113a bis 113c des ersten Substrates angeordnet, während die zweite Kontaktfläche 18 im zweiten Bereich 114 des ersten Substrates 11 angeordnet ist. Die ersten Kontaktflächen 17a bis 17c dienen zur Kontaktierung der ersten Bereiche 251a bis 251c der Strukturschicht 25, wobei eine elektrische Verbindung über die ersten Bereiche 113a bis 113c des ersten Substrates 11 realisiert wird. Die zweite Kontaktfläche 18 dient als Abschirmung des aktiven Bereiches des Bauteiles 1 gegenüber äußeren elektrischen Feldern und kann zur Bereitstellung eines definierten Potenzials oberhalb der aktiven Struktur 252 dienen. In der hier dargestellten Ausführungsform sind die Bereiche der Strukturschicht 25, die an den ersten Bereich 113c und an den zweiten Bereich 114 angrenzen physisch miteinander verbunden, wie aus Figur 1B ersichtlich ist. Falls die entsprechenden Bereiche der Strukturschicht 25 auch elektrisch leitend miteinander verbunden sind, kann die erste Kontaktfläche 17c auch eingespart werden.

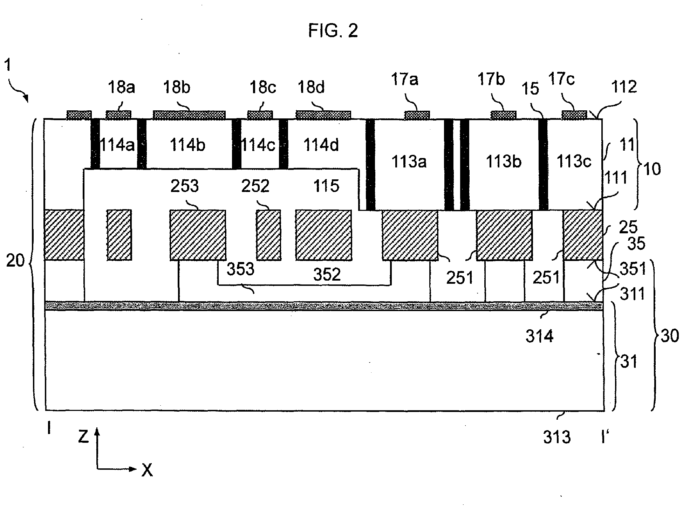

Figur 2 zeigt eine schematische Darstellung des Bauteils 1 gemäß einer weiteren Ausführungsform, wobei sich diese Ausführungsform von der in Figur 1A dargestellten Ausführungsform dadurch unterscheidet, dass mehrere zweite Bereiche 114a bis 114d im ersten Substrat 11 innerhalb der ersten Vertiefung 115 ausgebildet sind. Die zweiten Bereiche 114a bis 114d sind von den angrenzenden Bereichen des ersten Substrates 11 jeweils durch die mit isolierendem Material gefüllte Gräben 15 elektrisch isoliert. Die Gräben 15 entsprechen den in Figur 1A beschriebenen Gräben 15, die die verschiedenen ersten Bereiche 113a bis 113c von anderen Bereichen des ersten Substrates 11 elektrisch isolieren, und können bezüglich Form und isolierendem Material gleichartig oder verschieden zu diesen ausgebildet sein.

In jedem zweiten Bereich 114a bis 114d ist eine zugehörige zweite Kontaktfläche 18a bis 18d auf der zweiten Oberfläche 112 des ersten Substrates 11 angeordnet. Damit ist es möglich, verschiedenen oberhalb des aktiven Gebietes angeordneten Bereichen 114a bis 114c des ersten Substrates 11 unterschiedliche Potenziale zuzuordnen. So kann beispielsweise in den zweiten Bereichen 114a und 114c, die sich oberhalb der aktiven Struktur 252 befinden, ein Potenzial angelegt werden, das die Bewegung der aktiven Struktur 252 in z-Richtung begrenzt und damit ein Anstoßen der aktiven Struktur 252 an das erste Substrat 11 verhindert. Die zweiten Bereiche 114b und 114d können demgegenüber auf anderen Potenzialen gehalten werden, die lediglich einem Abschirmen der Strukturschicht 25 von äußeren elektrischen Feldern dienen soll.

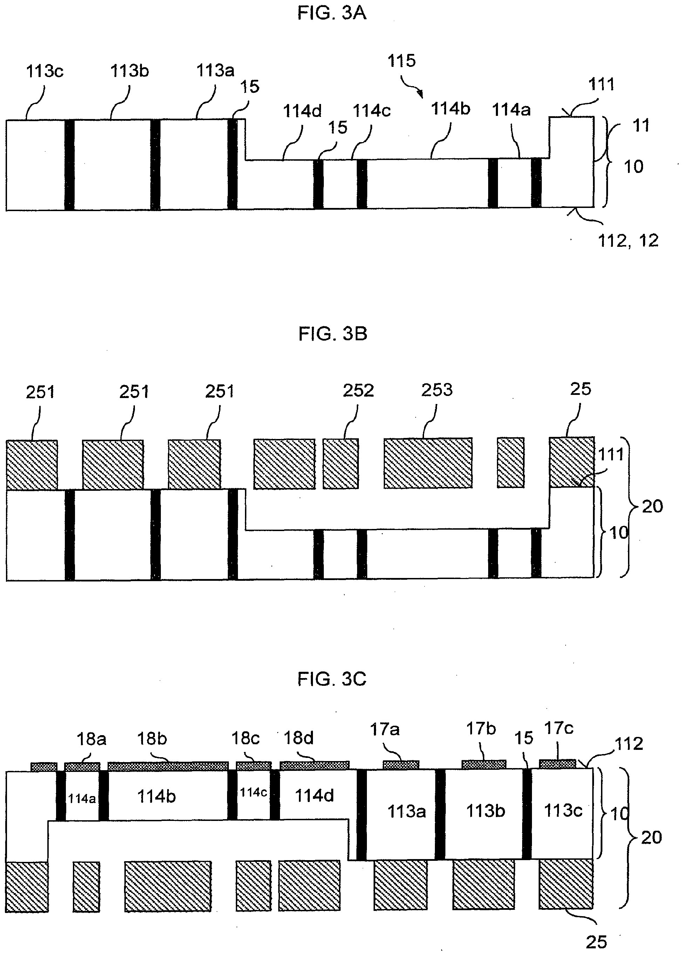

Anhand der Figuren 3A bis 3C wird eine erste Ausführungsform des erfindungsgemäßen Verfahrens zum Herstellen eines Bauteils anhand von Querschnittsdarstellungen beschrieben.

Wie in Figur 3A als Ergebnis dargestellt, wird zunächst ein erster Schichtverbund 10 erzeugt, der ein erstes Substrat 11 und mindestens einen mit isolierendem Material gefüllten Graben 15 umfasst. Die Gräben 15 können mithilfe eines Ätzverfahrens, beispielsweise eines Trockenätzverfahrens (DRIE) oder eines stark anisotropen Nassätzverfahrens, unter zu Hilfenahme einer Maske oder mit Hilfe von anderen Verfahren sowie einem anschließenden Füllprozess der entstandenen Gräben mit einem isolierendem Material erzeugt werden. Die Gräben 15 werden von der ersten Oberfläche 111 des ersten Substrates 11 aus erzeugt und können sich bis zur ersten Oberfläche 12 des ersten Schichtverbundes 10 erstrecken. Besteht der erste Schichtverbund 10, wie in Figur 3A dargestellt, nur aus dem ersten Substrat 11, so ist die zweite Oberfläche 112 des ersten Substrates 11 die erste Oberfläche 12 des ersten Schichtverbundes 10. In diesem Falle können die Gräben 15 auch ausgehend von der ersten Oberfläche 111 und der zweiten Oberfläche 112 des ersten Substrates 11 aus erzeugt werden, was insbesondere bei sehr dicken ersten Substraten 11 von Vorteil sein kann. Das isolierende Material, mit dem die Gräben 15 aufgefüllt werden, kann beispielsweise mit Hilfe eines chemischen oder physikalischen Abscheideverfahrens (CVD bzw. PVD) in die Gräben 15 gefüllt werden. Im Anschluss an das Auffüllen der Gräben 15 mit dem isolierenden Material wird überschüssiges isolierendes Material, das sich auf der ersten Oberfläche 111 und gegebenenfalls der zweiten Oberfläche 112 des ersten Substrates 11 befindet, wieder entfernt. Dies kann mit Hilfe eines chemischmechanischen Polierverfahrens (CMP) oder mit Hilfe eines Ätzprozesses durchgeführt werden.

In Figur 3A ist der Fall dargestellt, dass sich die Gräben 15 von der ersten Oberfläche 111 bis zur zweiten Oberfläche 112 des ersten Substrates 11 durchgehend erstrecken. Damit isolieren die Gräben 15 erste Bereiche 113a bis 113c des ersten Substrates 11 elektrisch von anderen Bereichen des ersten Substrates.

Gemäß einer Ausführungsform kann in der ersten Oberfläche 111 des ersten Substrates 11 eine erste Vertiefung 115 ausgebildet werden, deren Tiefe kleiner als die Dicke des ersten Substrates 11 ist. Das heißt, die erste Vertiefung 115 erstreckt sich nicht bis zur zweiten Oberfläche 112 des ersten Substrates 11. Wie in Figur 3A dargestellt, können innerhalb der ersten Vertiefung 115 ebenfalls mit isolierendem Material gefüllte Gräben 15 ausgebildet werden, die zweite Bereiche 114a bis 114d des ersten Substrates 11 elektrisch von anderen Bereichen des ersten Substrates 11 isolieren. Die Gräben 15 in der ersten Vertiefung 115 können gleichzeitig mit den Gräben 15 außerhalb der ersten Vertiefung 115 erzeugt werden oder in einem getrennten Prozessschritt. Die Gräben 15 können vor dem Erzeugen der ersten Vertiefung 115 oder danach erzeugt werden.

Der erste Schichtverbund 10 kann zunächst aus dem ersten Substrat 11 und einer an die zweite Oberfläche 112 des ersten Substrates 11 angrenzenden weiteren Schicht, einer Hilfsschicht, bestehen. Das erste Substrat 11 besteht aus einem elektrisch leitfähigem Material, beispielsweise einem Halbleitermaterial und insbesondere aus Silizium. Die erwähnte Hilfsschicht kann aus einem isolierendem Material, beispielsweise Siliziumoxid bestehen, die aber nach dem Ausbilden und Füllen der Gräben 15 wieder entfernt wird, so dass im Ergebnis des ersten Schrittes zum Erzeugen des ersten Schichtverbundes 10 sich die Gräben 15 von der ersten Oberfläche 111 des ersten Substrates 11 bis zur zweiten Oberfläche 112 des ersten Substrates 11 erstrecken und der erste Schichtverbund 10 nur das erste Substrat 11 und keine weiteren darauf angeordneten Schichten aufweist, wie dies in Figur 3A dargestellt ist.

Darüber hinaus kann die erwähnte Hilfsschicht auch ein Teil des ersten Substrates 11 sein. Das bedeutet, dass die Gräben 15 zunächst nicht durchgängig bis zur zweiten Oberfläche 112 des ersten Substrates 11 erzeugt werden, sondern eine Tiefe kleiner als die Dicker des ersten Substrates 11 aufweisen. Jedoch wird gemäß der in Figur 3A dargestellten Ausführungsform des Verfahrens das erste Substrat 11 von der zweiten Oberfläche 112 des ersten Substrates 11 aus bis zu der Tiefe der Gräben 15 abgedünnt, so dass die Gräben 15 an die zweite Oberfläche 112 des ersten Substrates 11 angrenzen. Damit liegt vor Erzeugen des zweiten Schichtverbundes 20 die in Figur 3A dargestellte Ausführungsform des ersten Schichtverbundes 10 vor.

In einem zweiten Schritt, der in Figur 3B dargestellt ist, wird ein zweiter Schichtverbund 20 erzeugt, der den ersten Schichtverbund 10 sowie eine Strukturschicht 25 umfasst, in der eine aktive Struktur 252 sowie erste Bereiche 251 ausgebildet sind. Die Strukturschicht 25 ist zumindest in den ersten Bereichen 251 elektrisch leitfähig. Der zweite Schichtverbund 20 kann durch das Aufbringen der Strukturschicht 25 auf den ersten Schichtverbund 10 oder durch ein Verbinden der Strukturschicht 25 mit dem ersten Schichtverbund 10 erzeugt werden. Dabei kann die Strukturschicht 25 zunächst als unstrukturierte Schicht auf der ersten Oberfläche 111 des ersten Substrates 11 aufgebracht oder mit dieser verbunden werden und danach strukturiert werden, um die aktive Struktur 252 zu erzeugen. Dies kann beispielsweise durch einen Ätzprozess realisiert werden, in dem auch die ersten Bereiche 251 erzeugt werden können. Die ersten Bereiche 251 können jedoch auch als elektrisch voneinander isolierte, leitende Bereiche innerhalb der Strukturschicht 25 ausgebildet werden, beispielsweise durch Dotierungsprozesse in einer Halbleiterschicht, wobei die einzelnen ersten Bereiche 251 nicht notwendigerweise physisch voneinander getrennt sein müssen.

Die Strukturschicht 25 kann mithilfe eines Abscheideverfahrens auf der Oberfläche 111 des ersten Substrates 11 aufgebracht werden, beispielsweise unter Verwendung einer Hilfsschicht, die zunächst die erste Vertiefung 115 auffüllt und nach dem Abscheiden und Strukturieren der Strukturschicht 25 selektiv wieder entfernt wird. Jedoch kann die Strukturschicht 25 als unstrukturierte Schicht oder als bereits strukturierte Schicht auch mithilfe eines Fügeverfahrens, beispielsweise Silizium-Direkt-Bonden (SDB), anodisches Bonden oder anderer Verfahren, mit der Oberfläche 111 des ersten Substrates 11 verbunden werden. Dies bietet sich besonders dann an, wenn eine eingangs erwähnte hermetisch dichte Verkapselung eines aktiven Gebietes erreicht werden soll. Für ein Fügeverfahren kann es besonders vorteilhaft sein, wenn die zu verbindenden Schichten, in diesem Falle das erste Substrat 11 und die Strukturschicht 25, aus demselben Material bestehen.

In einem weiteren Schritt der ersten Ausführungsform des erfindungsgemäßen Verfahrens werden erste Kontaktflächen 17a bis 17c auf der zweiten Oberfläche 112 des ersten Substrates 11 in den ersten Bereichen 113a bis 113c des ersten Substrates 11 erzeugt. Darüber hinaus können zweite Kontaktflächen 18a bis 18d auf der zweiten Oberfläche 112 des ersten Substrates 11 in den zweiten Bereichen 114a bis 114d des ersten Substrates 11 erzeugt werden. Die ersten Kontaktflächen 17a bis 17c und die zweiten Kontaktflächen 18a bis 18d können aus ein und demselben oder aus unterschiedlichen elektrisch leitfähigen Materialien bestehen und können in einem oder in verschiedenen Prozessschritten erzeugt werden. Beispielsweise kann eine metallische Schicht auf der zweiten Oberfläche 112 des ersten Substrates 11 aufgebracht und nachfolgend mittels eines Ätzverfahrens oder eines Lift-off-Prozesses strukturiert werden, so dass die ersten Kontaktflächen 17a bis 17c und die zweiten Kontaktfläche 18a bis 18d entstehen.

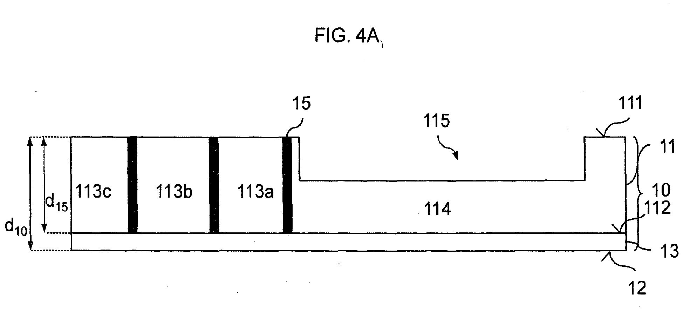

Die Figuren 4A bis 4D zeigen verschiedene Prozessschritte einer zweiten Ausführungsform des erfindungsgemäßen Verfahrens zum Herstellen eines Bauteils.

Zunächst wird in einem ersten Prozessschritt ein erster Schichtverbund 10 erzeugt, der ein erstes Substrat 11 und mindestes einen im ersten Substrat 11 ausgebildeten und mit einem isolierenden Material gefüllten Graben 15 umfasst, wobei sich der mindestens eine Graben 15 von der ersten Oberfläche 111 des ersten Substrates 11 aus erstreckt. Wie in Figur 4A dargestellt, erstrecken sich der bzw. die Gräben 15 jedoch nicht bis zur ersten Oberfläche 12 des ersten Schichtverbundes 10, die der ersten Oberfläche 111 des ersten Substrates 11 gegenüberliegt. Das heißt, die Tiefe d₁₅ der Gräben 15 ist kleiner als die Dicke d₁₀ des ersten Schichtverbundes 10. Wie bereits mit Bezug auf die Figur 3A beschrieben, kann der erste Schichtverbund 10 neben dem ersten Substrat 11 eine Hilfsschicht 13 umfassen, die an die zweite Oberfläche 112 des ersten Substrates 11 angrenzt und in der keine Gräben 15 ausgebildet sind. Alternativ kann der erste Schichtverbund 10 nur das erste Substrat 11 umfassen, wobei jedoch die Gräben 15 sich nicht bis zur zweiten Oberfläche 112 des ersten Substrates 11 erstrecken. Mit anderen Worten: die in Figur 4A dargestellte Hilfsschicht 13 kann ein Teil des ersten Substrates 11 sein. Im Unterschied zu der mit Bezug auf die Figur 3A beschriebenen ersten Ausführungsform des Verfahrens bleibt jedoch die Hilfsschicht 13 zunächst erhalten, das heißt, sie wird vor dem Erzeugen des zweiten Schichtverbundes 20 nicht entfernt.

Wie in Figur 4A dargestellt, kann eine erste Vertiefung 115 in der ersten Oberfläche 111 des ersten Substrates 11 ausgebildet werden, innerhalb der ein zweiter Bereich 114 des ersten Substrates angeordnet ist. Darüber hinaus können, wie in Figur 3A dargestellt, die Gräben 15 auch in einem Bereich des Substrates 11 ausgebildet sein, der an die erste Vertiefung 115 angrenzt, so dass mehrere zweite Bereiche 114, wie in Figur 3A dargestellt, erzeugt werden. Im Ergebnis des ersten Prozessschrittes der zweiten Ausführungsform des Verfahrens liegt der in Figur 4A dargestellte erste Schichtverbund 10 vor.

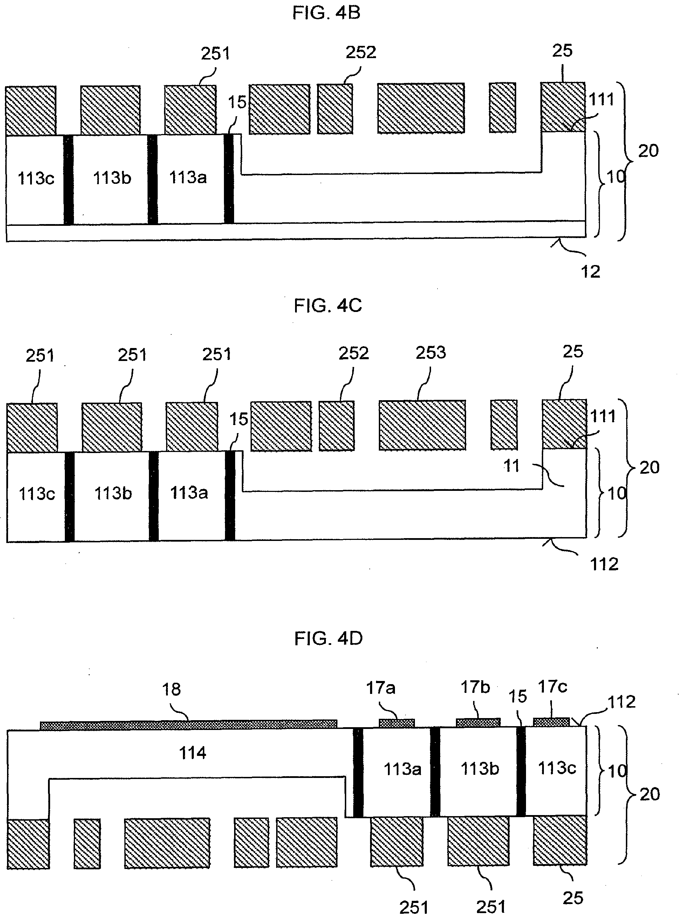

Anschließend wird in einem weiteren Prozessschritt ein zweiter Schichtverbund 20 erzeugt, indem eine Strukturschicht 25 auf der ersten Oberfläche 111 des ersten Substrates 11 aufgebracht oder mit der ersten Oberfläche 111 des ersten Substrates 11 verbunden wird. Das Ergebnis ist in Figur 4B dargestellt. Dies entspricht dem Prozessschritt, der mit Bezug auf Figur 3B beschrieben wurde, wobei sich jedoch die Gräben 15 vor dem Erzeugen des zweiten Schichtverbundes 20 nicht bis zur ersten Oberfläche 12 des ersten Schichtverbundes 10 erstrecken. Diese Ausführungsform des Verfahrens hat gegenüber der ersten Ausführungsform des Verfahrens den Vorteil, dass der erste Schichtverbund 10 während des Erzeugens des zweiten Schichtverbundes 20 eine größere Stabilität aufweist, da die einzelnen lateralen Bereich des Schichtverbundes 10, beispielsweise die Bereiche 113a bis 113c, noch über die Hilfsschicht 13 miteinander verbunden sind. Damit können insbesondere bei einem Fügeprozess zum Verbinden der Strukturschicht 25 mit der ersten Oberfläche 111 des ersten Substrates 11 Prozessparameter verwendet werden, die zu einer stabileren und dichteren Verbindung zwischen der Strukturschicht 25 und dem ersten Substrat 11 führen. Ein Beispiel dafür sind höhere Drücke bei einem Bondverfahren.

In einem nächsten Prozessschritt, dessen Ergebnis in Figur 4C dargestellt ist, wird die Hilfsschicht 13 entfernt. Dies kann mithilfe eines CMP-Prozesses oder eines Ätzprozesses durchgeführt werden. Dabei wird die Hilfsschicht 13 soweit entfernt, bis die Gräben 15 erreicht werden. Im Ergebnis grenzen die Gräben 15 an die zweite Oberfläche 112 des ersten Substrates 11 an und isolieren damit die Bereiche 113a bis 113c des ersten Substrates 11 elektrisch von anderen Bereichen des ersten Substrates 11.

In einem nächsten Prozessschritt, dargestellt in Figur 4D, werden erste Kontaktfläche 17a bis 17c und eine zweite Kontaktfläche 18 auf der zweiten Oberfläche 112 des ersten Substrates 11 erzeugt. Dieser Prozess entspricht dem in Figur 3C dargestellten Prozessschritt. Im Ergebnis können die Bereiche 251 über die jeweiligen ersten Bereiche 113a bis 113c des ersten Substrates 11 und die dazugehörigen jeweiligen ersten Kontaktflächen 17a bis 17c kontaktiert werden, während die zweite Kontaktfläche 18 eine Schirmelektrode bildet, die das aktive Gebiet des Bauelementes 1 von äußeren elektrischen Feldern abschirmt. Alternativ können auch mehrere Kontaktflächen 18 ausgebildet werden, um gegebenenfalls mehrere ausgebildete zweite Bereiche 114 des ersten Substrates 11 zu kontaktieren, wie dies in Figur 3C dargestellt ist.

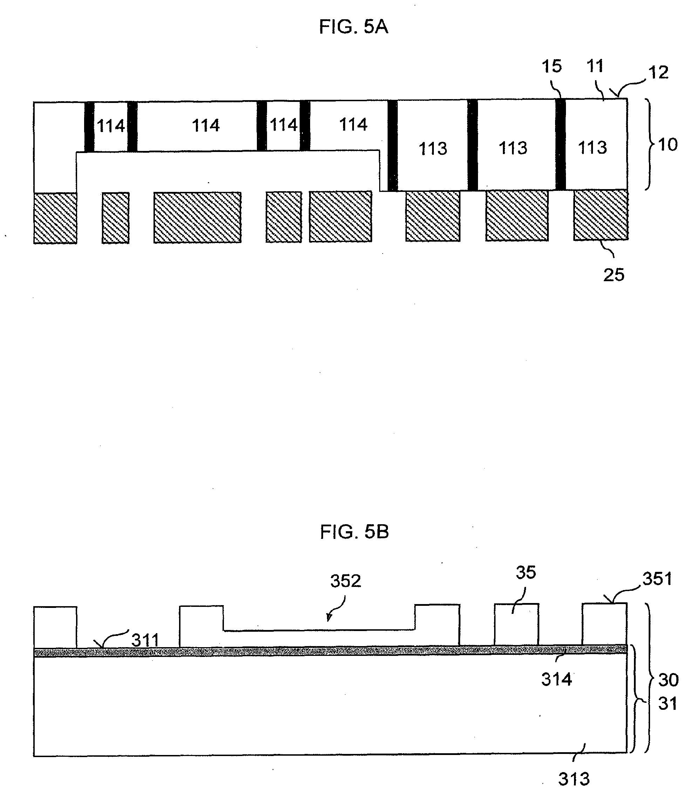

Anhand der Figuren 5A bis 5C wird eine dritte Ausführungsform des erfindungsgemäßen Verfahrens zur Herstellung eines Bauteils 1 erläutert.

Zunächst wird, wie in Figur 5A dargestellt, der erste Schichtverbund 10, der das erste Substrat 11 und den mindestens einen mit einem isolierenden Material gefüllten Graben 15 umfasst, mit der Strukturschicht 25 verbunden, wie dies mit Bezug auf die Figuren 3A und 3B erläutert wurde. Jedoch kann der erste Schichtverbund 10 auch entsprechend der Prozessschritte, die in Figuren 4A und 4B oder 4A bis 4C dargestellt sind, erzeugt werden. Das heißt, der erste Schichtverbund 10 kann neben ersten Bereichen 113 auch nur einen zweiten Bereich 114 aufweisen. Darüber hinaus kann der erste Schichtverbund 10 so ausgebildet sein, dass sich die Gräben 15 nach dem Verbinden des ersten Schichtverbundes 10 mit der Strukturschicht 25 bis zur ersten Oberfläche 12 des ersten Schichtverbundes 10 erstrecken, wie in Figur 3B beziehungsweise in Figur 4C dargestellt. Jedoch können die Gräben 15 sich auch noch nicht bis zur ersten Oberfläche 12 des ersten Schichtverbundes 10 erstrecken, was der in Figur 4B dargestellten Ausführungsform entspricht.

In einem weiteren Prozessschritt, dessen Ergebnis in Figur 5B dargestellt ist, wird ein dritter Schichtverbund 30 erzeugt. Die Erzeugung des dritten Schichtverbundes 30 kann unabhängig von dem in Figur 5A dargestellten Prozessschritt erfolgen, beispielsweise zeitlich vor oder nach dem in Figur 5A dargestellten Prozessschritt. Gemäß einer Ausführungsform umfasst der dritte Schichtverbund 30 ein drittes Substrat 31 mit einer ersten Schicht 313 und einer zweiten Schicht 314 sowie eine Deckschicht 35. Die Deckschicht 35 wird strukturiert und bildet Leitbahnen aus, die verschiedene Bereiche der Deckschicht 35 miteinander verbinden. Dabei können auch zweite Vertiefungen 352, die sich von der ersten Oberfläche 351 der Deckschicht 35 aus erstrecken, erzeugt werden. Der Begriff "Strukturieren" kann hierbei sowohl das Erzeugen von elektrisch leitfähigen Bereichen, die elektrisch voneinander isoliert, jedoch physisch nicht voneinander getrennt sind, z.B. durch Dotieren einer Halbleiterschicht, oder die physische Trennung elektrisch leitfähiger Bereiche voneinander umfassen.

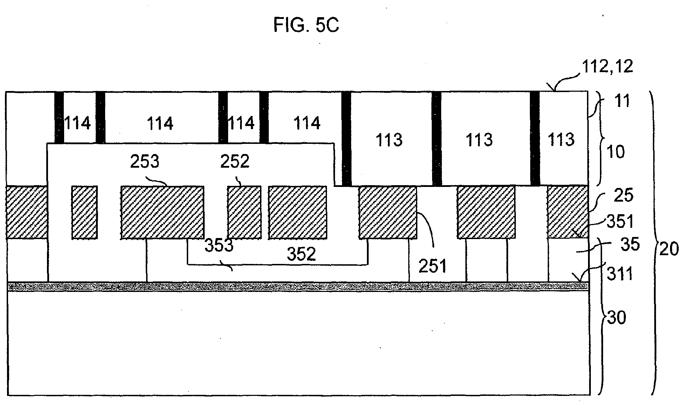

In einem weiteren Prozessschritt, dessen Ergebnis in Figur 5C dargestellt ist, wird ein zweiter Schichtverbund 20 erzeugt, indem die Strukturschicht 25 und der mit ihr verbundene erste Schichtverbund 10 mit dem dritten Schichtverbund 30 verbunden werden. Dies kann durch ein Fügeverfahren wie oben beschrieben realisiert werden. Dafür ist es insbesondere vorteilhaft, dass die Strukturschicht 25 und die der Strukturschicht 25 zugewandte Schicht des dritten Schichtverbundes 30, in diesem Falle die Deckschicht 35, aus demselben Material bestehen. Dieses Material kann beispielsweise Silizium sein. Im Ergebnis grenzen erste Bereiche 251 der Strukturschicht 25 an die Oberfläche 351 der Deckschicht 35 an. Damit ist es möglich, innerhalb der Deckschicht 35 leitende Verbindungen zwischen innerhalb der Strukturschicht 25 elektrisch voneinander isolierten, leitenden Bereichen der Strukturschicht 25 herzustellen. Beispielsweise kann der an die erste Vertiefung 352 angrenzender Bereich der Deckschicht eine Leiterbahnbrücke 353 bilden, der einen ersten Bereich 251 der Strukturschicht 25 mit einem zweiten Bereich 253 der Strukturschicht verbindet und dabei die aktive Struktur 252 überbrückt.

Für den Fall, dass sich vor dem Erzeugen des zweiten Schichtverbundes 20 der oder die Gräben 15 nicht bis zur ersten Oberfläche 12 des ersten Schichtverbundes 10 erstrecken, wird nach dem Verbinden der Strukturschicht 25 und des ersten Schichtverbundes 10 mit dem dritten Schichtverbund 30 der erste Schichtverbund 10 von der ersten Oberfläche 12 aus so weit abgedünnt, dass die Gräben 15 an die erste Oberfläche 12 des ersten Schichtverbundes 10 angrenzen. Mit anderen Worten: Im Ergebnis entspricht die zweite Oberfläche 112 des ersten Substrates 11 der ersten Oberfläche 12 des ersten Schichtverbundes 10.

In einem weiteren Prozessschritt werden erste Kontaktflächen 17a bis 17c sowie gegebenenfalls eine zweite Kontaktfläche 18 oder mehrere zweite Kontaktflächen 18a bis 18d auf der zweiten Oberfläche 112 des ersten Substrates 11 erzeugt, so dass im Ergebnis das in Figur 1A beziehungsweise Figur 2 dargestellte Bauteil 1 vorliegt.

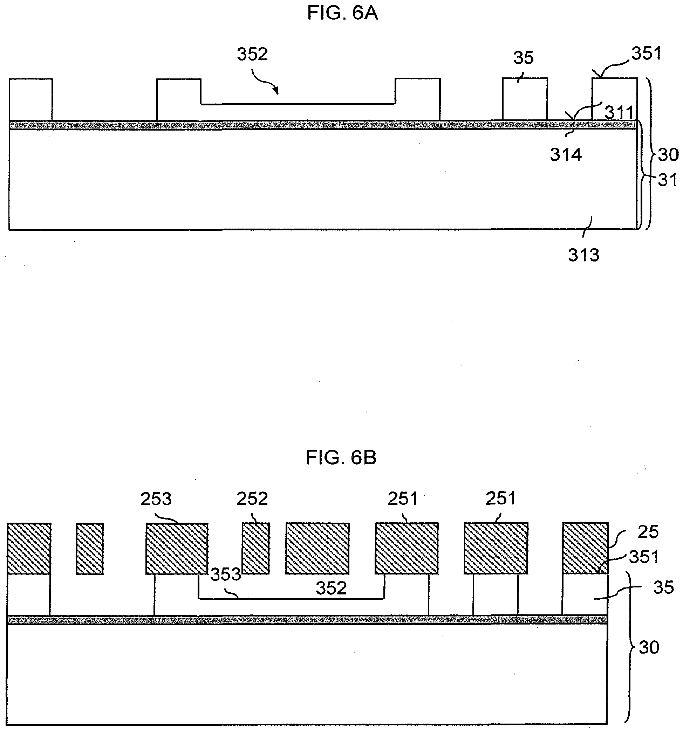

Die Figuren 6A bis 6D zeigen Prozessschritte einer vierten Ausführungsform des erfindungsgemäßen Verfahrens zum Herstellen eines Bauteils.

Gemäß dieser Ausführungsform wird zunächst ein dritter Schichtverbund 30, der ein drittes Substrat 31 und eine zumindest in einem Bereich leitfähige Deckschicht 35 umfasst. Damit entspricht der in Figur 6A dargestellte dritte Schichtverbund 30 dem in Figur 5B dargestellten dritten Schichtverbund 30.

In einem weiteren Prozessschritt wird auf der ersten Oberfläche 351 der Deckschicht 35 die Strukturschicht 25 erzeugt, wobei die Strukturschicht 25 auf der Oberfläche 351 der Deckschicht 35 als Schicht aufgebracht werden kann oder mit der Oberfläche 351 der Deckschicht 35 durch ein Fügeverfahren verbunden werden kann. Dabei kann die Strukturschicht 25 zunächst als unstrukturierte Schicht 25 vorliegen, die nachfolgend strukturiert wird, um einzelne erste Bereiche 251, eine aktive Struktur 252 und gegebenenfalls weitere Bereiche, zum Beispiel zweite Bereiche 253, zu erzeugen. Alternativ kann die Strukturschicht 25 bereits als strukturierte Schicht auf die Oberfläche 351 der Deckschicht 35 aufgebracht oder mit dieser verbunden werden. Das Ergebnis dieses Prozessschrittes ist in Figur 6B dargestellt.

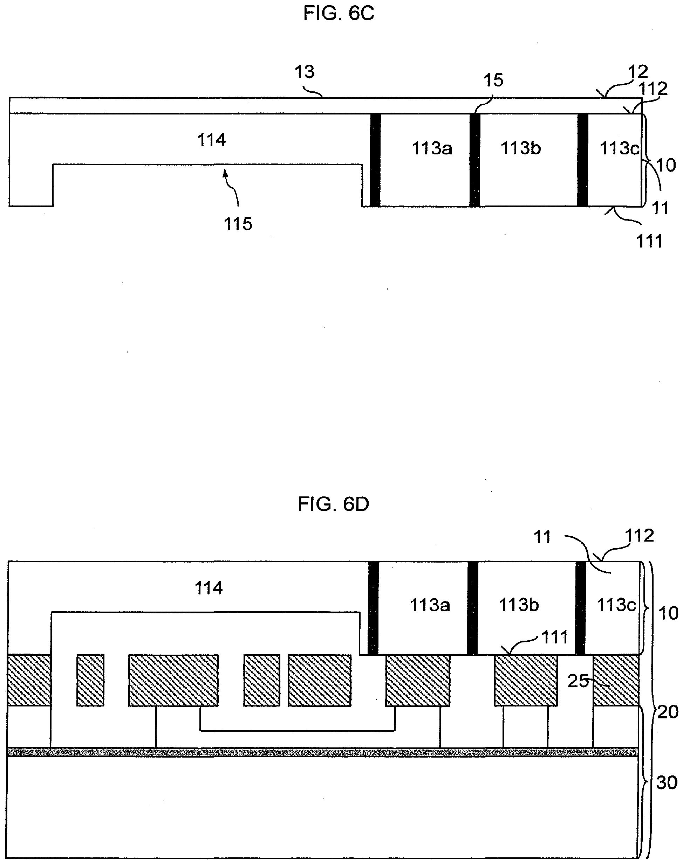

In einem weiteren Prozessschritt, dessen Ergebnis in Figur 6C dargestellt ist, wird ein erster Schichtverbund 10 erzeugt, der ein erstes Substrat 11, mindestens einen mit isolierendem Material gefüllten Graben 15 sowie eine Hilfsschicht 13 umfasst. Der oder die Gräben 15 erstrecken sich von einer ersten Oberfläche 111 des ersten Substrates 11 aus und isolieren erste Bereiche 113a bis 113c des ersten Substrates 11 an der ersten Oberfläche 111 lateral von anderen Bereichen des ersten Substrates 11. Im ersten Substrat 11 können weiterhin eine oder mehrere erste Vertiefungen 115 ausgebildet sein, innerhalb der ein zweiter Bereich 114 angeordnet ist. Damit entspricht der erste Schichtverbund 10 dem in Figur 4A dargestellten ersten Schichtverbund 10, wobei die Aussagen zur Herstellung dieses ersten Schichtverbundes 10 ebenfalls gelten.

Der Prozessschritt zum Erzeugen des ersten Schichtverbundes 10 kann zeitlich vor oder nach den in Figuren 6A und 6B dargestellten Prozessschritten erfolgen.

In einem nächsten Prozessschritt, dessen Ergebnis in Figur 6D dargestellt ist, wird ein zweiter Schichtverbund 20 erzeugt, in dem der erste Schichtverbund 10 mit der Strukturschicht 25 und dem dritten Schichtverbund 30 verbunden wird. Im Ergebnis grenzt die erste Oberfläche 111 des ersten Substrates 11 zumindest in spezifischen Bereichen an die Strukturschicht 25 an. Das Erzeugen des zweiten Schichtverbundes 20 kann insbesondere durch einen Fügeprozess erfolgen. In diesem Zusammenhang ist das Vorhandensein der Hilfsschicht 13 während des Fügeprozesses von Vorteil, da dadurch besonders geeignete Fügeparameter, beispielsweise hohe Drücke, eingesetzt werden können, die zu einer guten und hermetisch dichten Verbindung zwischen dem ersten Schichtverbund 10 und der Strukturschicht 25 führen. Im Anschluss an das Verbinden des ersten Schichtverbundes 10 mit der Strukturschicht 25 wird die Hilfsschicht 13 entfernt, wie dies mit Bezug auf Figur 4C erläutert wurde, so dass im Ergebnis die zweite Oberfläche 112 des ersten Substrates 11 frei zugänglich ist. Dabei erstrecken sich die Gräben 15 bis zur zweiten Oberfläche 112 und isolieren damit elektrisch die einzelnen ersten Bereiche 113a bis 113c von anderen Bereichen des ersten Substrates 11.

Alternativ kann die Deckschicht 13 auch bereits vor dem Verbinden des ersten Schichtverbundes 10 mit der Strukturschicht 25 entfernt werden.

In einem weiteren Prozessschritt werden auf der Oberfläche 112 des ersten Substrates 11 erste Kontaktflächen 17a bis 17c sowie eine oder mehrere zweite Kontaktflächen 18 erzeugt, wie dies mit Bezug auf die Figuren 3C und 4D beschrieben wurde. Im Ergebnis liegt ein Bauteil 1 wie in Figur 1A beziehungsweise Figur 2 dargestellt vor.

Es sind neben den in den Figuren 3A bis 6D dargestellten Ausführungsformen weitere Ausführungsformen des ersten Schichtverbundes 10, der Strukturschicht 25, des dritten Schichtverbundes 30 und des zweiten Schichtverbundes 20 möglich, sowie verschiedenste Kombinationen dieser Ausführungsformen. Beispielsweise können zweite Bereiche 114a bis 114d im ersten Substrat 11 ausgebildet sein oder auch nicht. Das Gleiche gilt für die erste Vertiefung 115 im ersten Substrat 11. Auch die Deckschicht 35 ist nicht notwendigerweise vorhanden und in der hier dargestellten Form strukturiert. Die Anzahl der ersten Bereiche 113 des ersten Substrates 11 und der zweiten Bereiche 114 des ersten Substrates 11 sowie der ersten Bereiche 251 der Strukturschicht 25 sowie der ersten Kontaktflächen 17 und der zweiten Kontaktflächen 18 sind frei wählbar.

Ein Vorteil des erfindungsgemäßen Verfahrens zur Herstellung des Bauteils 1 ist, dass die Oberfläche 112 des ersten Substrates 11 vor dem Erzeugen der ersten Kontaktflächen 17 und gegebenenfalls der zweiten Kontaktflächen 18 vollständig oder nahezu eben ist, das heißt, keine oder keine größeren Höhenunterschiede aufweist. Dies ist vor allem für das Ausbilden der ersten Kontaktflächen 17 und der zweiten Kontaktfläche 18 sowie für spätere Prozessschritte, beispielsweise das Vereinzeln der Bauteile 1 sowie die Montage des Bauteiles 1 auf einem Träger und das Verbinden der Kontaktflächen 17 und 18 mit anderen Bauelementen eines Systems vorteilhaft. Wird zur Kontaktierung der Kontaktflächen 17 und 18 mit anderen Bauelementen eines Systems ein Drahtbondprozess verwendet, so wird der Bondprozess dadurch vereinfacht, dass sich die zu kontaktierende Kontaktfläche 17 oder 18 nicht in einem engen Durchbruch in einer Abdeckung des Bauteils befindet. Darüber hinaus können auch andere Verbindungsprozesse, beispielsweise Flip-Chip-Bonden oder Ball-Grid-Bonden, zur Kontaktierung der Kontaktflächen 17 und 18 mit anderen Bauelementen eines Systems eingesetzt werden. Darüber hinaus kann der Flächenbedarf für die Kontaktflächen 17 und 18 gegenüber einem Drahtbondanschluss, der in einem tiefen Durchbruch der Abdeckung des Bauteils realisiert wird, um bis zu einen Faktor 100 verringert werden. Weiterhin weist die parasitäre Kapazität einer ersten Kontaktfläche 17 zu einer zweiten Kontaktfläche 18, die als Schirmelektrode dient, eine circa vierzigmal geringere Größe bei gleicher Dielektrizitätskonstante auf.

Des Weiteren kann die Dichtigkeit der hermetischen Verkapselung des aktiven Gebietes des Bauteils 1 sichergestellt werden. Insbesondere können geeignete Fügeparameter während des Fügeprozesses zur Verbindung der Strukturschicht 25 mit dem ersten Schichtverbund 10 oder der bereits auf dem ersten Schichtverbund 10 aufgebrachten Strukturschicht 25 mit dem dritten Schichtverbund 30 gewählt werden.

## Patentansprüche

1. Verfahren zum Herstellen eines Bauteils (1), umfassend:
Erzeugen eines ersten Schichtverbundes (10), der ein erstes Substrat (11) aus einem elektrisch leitenden Material und mindestens einen mit einem isolierenden Material gefüllten Graben (15), der sich von einer ersten Oberfläche (111) des ersten Substrates (11) aus erstreckt, umfasst, wobei ein erster Bereich (113) des ersten Substrates (11) durch den mindestens einen Graben (15) an der ersten Oberfläche (111) lateral von anderen Bereichen des ersten Substrates (11) elektrisch isoliert ist,
Erzeugen eines zweiten Schichtverbundes (20), der den ersten Schichtverbund (10) und eine Strukturschicht (25), die eine aktive Struktur (252) des Bauteils umfasst und die mindestens in einem ersten Bereich (251) elektrisch leitfähig ist, umfasst, wobei der erste Bereich (251) der Strukturschicht (25) in dem ersten Bereich (113) des ersten Substrates (11) an die erste Oberfläche (111) des ersten Substrates (11) angrenzt und mit diesem elektrisch leitend verbunden ist, und
Erzeugen einer ersten elektrisch leitenden Kontaktfläche (17) auf einer zweiten Oberfläche (112) des ersten Substrates (11), wobei die zweite Oberfläche (112) der ersten Oberfläche (111) gegenüberliegt und wobei die erste Kontaktfläche (17) in dem ersten Bereich (113) des ersten Substrates (11) angeordnet ist, wobei der erste Bereich (113) des ersten Substrates (11) durch den mindestens einen Graben (15) an der zweiten Oberfläche (112) lateral von anderen Bereichen des ersten Substrates (11) elektrisch isoliert ist, wobei
beim Erzeugen des ersten Schichtverbundes (10) eine erste Vertiefung (115) in der ersten Oberfläche (111) des ersten Substrates (11) erzeugt wird, wobei die erste Vertiefung (115) eine Tiefe kleiner als die Dicke des ersten Substrates (11) aufweist und wobei der erste Bereich (113) des ersten Substrates (11) außerhalb der ersten Vertiefung (115) angeordnet ist und ein zweiter Bereich (114) des ersten Substrates (11) innerhalb der erste Vertiefung (115) angeordnet ist, wobei der zweite Bereich (114) des ersten Substrates (11) durch den mindestens einen Graben (15) an der ersten Oberfläche (111) des ersten Substrates (11) lateral von anderen Bereichen des ersten Substrates (11) elektrisch isoliert ist, und wobei
beim Erzeugen des zweiten Schichtverbundes (20) mindestens ein Teil der aktiven Struktur (252) innerhalb der ersten Vertiefung (115) mit einem Abstand zum ersten Substrat (11) angeordnet wird, und
eine zweite elektrisch leitende Kontaktfläche (18) auf der zweiten Oberfläche (112) des ersten Substrates (11) erzeugt wird, wobei die zweite Kontaktfläche im zweiten Bereich (114) des ersten Substrates (11) angeordnet ist und wobei der zwei-te Bereich (114) des ersten Substrates (11) durch den mindestens einen Graben (15) an der zweiten Oberfläche (112) lateral von anderen Bereichen des ersten Substrates (11) elektrisch isoliert ist,
**dadurch gekennzeichnet, dass**
der erste Schichtverbund (10) mindestens zwei mit isolierendem Material gefüllte Gräben (15) umfasst,
mindestens zwei zweite Bereiche (114) des ersten Substrates (11) innerhalb der ersten Vertiefung (115) angeordnet sind, und
mindestens zwei zweite Kontaktflächen (18) auf der zweiten Oberfläche (112) des ersten Substrates (11) erzeugt werden, wobei jede zweite Kontaktfläche (18) in einem der zweiten Bereiche (114) des ersten Substrates (11) angeordnet ist.

2. Verfahren zum Herstellen eines Bauteils (1) nach Anspruch 1,
**dadurch gekennzeichnet, dass**
der erste Schichtverbund (10) nur das erste Substrat (11) und den mindestens einen Graben (15) umfasst und
sich der mindestens eine Graben (15) im ersten Substrat (11) vor dem Erzeugen des zweiten Schichtverbundes (20) bis zur zweiten Oberfläche (112) des ersten Substrates (11) erstreckt.

3. Verfahren zum Herstellen eines Bauteils (1) nach einem der Ansprüche 1 und 2,
**dadurch gekennzeichnet, dass**
sich der mindestens eine Graben (15) im ersten Schichtverbund (10) vor dem Erzeugen des zweiten Schichtverbundes (20) bis zu einer Tiefe erstreckt, die kleiner als die Dicke des ersten Schichtverbundes (10) ist, und
vor dem Erzeugen der ersten Kontaktfläche (17) die Dicke des ersten Schichtverbundes (10) von einer ersten Oberfläche (12) des ersten Schichtverbundes (10) aus bis zur Tiefe des mindestens einen Grabens (15) reduziert wird, wobei die erste Oberfläche (12) des ersten Schichtverbundes (10) die Oberfläche des ersten Schichtverbundes (10) ist, die der ersten Oberfläche (111) des ersten Substrates (11) gegenüberliegt.

4. Verfahren zum Herstellen eines Bauteils (1) nach einem der vorhergehenden Ansprüche,
**dadurch gekennzeichnet, dass**
der zweite Schichtverbund (20) weiterhin einen dritten Schichtverbund (30) umfasst, der auf der dem ersten Schichtverbund (10) gegenüberliegenden Seite an die Substratschicht (25) angrenzt und ein zweites Substrat (31) umfasst.

5. Verfahren zum Herstellen eines Bauteils (1) nach Anspruch 4,
**dadurch gekennzeichnet, dass**
das Erzeugen des zweiten Schichtverbundes (20) umfasst:
Erzeugen der Strukturschicht (25) auf der ersten Oberfläche (111) des ersten Substrates (11), und
Verbinden der auf dem ersten Schichtverbund (10) aufgebrachten Strukturschicht (25) mit dem dritten Schichtverbund (30).

6. Verfahren zum Herstellen eines Bauteils (1) nach Anspruch 4,
**dadurch gekennzeichnet, dass**
das Erzeugen des zweiten Schichtverbundes (20) umfasst:
Erzeugen der Strukturschicht (25) auf dem dritten Schichtverbund (30), und
Verbinden der auf dem dritten Schichtverbund (30) aufgebrachten Strukturschicht (25) mit dem ersten Schichtverbund (10).

7. Verfahren zum Herstellen eines Bauteils (1) nach einem der Ansprüche 4 bis 6,
**dadurch gekennzeichnet, dass**
der dritte Schichtverbund (30) eine mindestens in einem Bereich leitfähige Deckschicht (35) umfasst, wobei die Deckschicht (35) auf einer ersten Oberfläche (311) des zweiten Substrates (31) angeordnet ist, wobei die erste Oberfläche (311) des zweiten Substrates (31) die der Strukturschicht (25) zugewandte Oberfläche des zweiten Substrates (31) ist,
eine zweite Vertiefung (352) in einer ersten Oberfläche (351) der Deckschicht (35) erzeugt wird, wobei die erste Oberfläche (351) der Deckschicht (35) die der Strukturschicht (25) zugewandte Oberfläche der Deckschicht (35) ist und wobei die Tiefe der zweiten Vertiefung (352) kleiner als die Dicke der Deckschicht (35) ist, und
beim Erzeugen des zweiten Schichtverbundes (20) der leitfähige Bereich der Deckschicht (35) an den ersten Bereich (251) der Strukturschicht (25) und an einen zweiten Bereich (253) der Strukturschicht (25) angrenzend angeordnet wird, wobei der erste Bereich (251) der Strukturschicht (25) außerhalb der aktiven Struktur (252) angeordnet ist und der zweite Bereich (253) der Strukturschicht (25) innerhalb der aktiven Struktur (252) angeordnet und elektrisch leitfähig ist, und die zweite Vertiefung (352) und mindestens ein Teil der aktiven Struktur (252) so angeordnet werden, dass die laterale Position der zweiten Vertiefung (352) der lateralen Position des mindestens einen Teils der aktiven Struktur (252) entspricht, wobei die Deckschicht (35) eine Leiterbahnbrücke (353) bildet, die den zweiten Bereich (253) der Strukturschicht (25) mit dem ersten Bereich (251) der Strukturschicht (25) verbindet.

8. Verfahren zum Herstellen eines Bauteils (1) nach einem der Ansprüche 4 bis 7,
**dadurch gekennzeichnet, dass**
die Strukturschicht (25) und die der Strukturschicht (25) zugewandte Schicht des dritten Schichtverbundes (30) aus dem selben Material bestehen.

9. Verfahren zum Herstellen eines Bauteils (1) nach einem der vorhergehenden Ansprüche,
**dadurch gekennzeichnet, dass**
das erste Substrat (11) und die Strukturschicht (25) aus dem selben Material bestehen.

10. Bauteil (1) mit:
einem ersten Schichtverbund (10), der ein erstes Substrat (11) aus einem elektrisch leitenden Material und mindestens einen mit einem isolierenden Material gefüllten Graben (15), der sich von einer ersten Oberfläche (111) des ersten Substrates (11) aus bis zu einer zweiten Oberfläche (112) des ersten Substrates (11) erstreckt, umfasst, wobei die zweite Oberfläche (112) der ersten Oberfläche (111) gegenüberliegt und wobei ein erster Bereich (113) des ersten Substrates (11) durch den mindestens einen Graben (15) lateral von anderen Bereichen des ersten Substrates (11) elektrisch isoliert ist,
eine Strukturschicht (25), die eine aktive Struktur (252) des Bauteils (1) umfasst und die mindestens in einem ersten Bereich (251) elektrisch leitfähig ist, wobei der erste Bereich (251) der Strukturschicht (25) in dem ersten Bereich (113) des ersten Substrates (11) an die erste Oberfläche (111) des ersten Substrates (11) angrenzt und mit dem ersten Bereich (113) des ersten Substrates (11) elektrisch leitend verbunden ist, und
eine elektrisch leitende Kontaktfläche (17) auf der zweiten Oberfläche (112) des ersten Substrates (11), wobei die erste Kontaktfläche (17) in dem ersten Bereich (113) des ersten Substrates (11) angeordnet ist, wobei
in der ersten Oberfläche (111) des ersten Substrates (11) eine erste Vertiefung (115) ausgebildet ist, wobei die erste Vertiefung (115) eine Tiefe kleiner als die Dicke des ersten Substrates (11) aufweist und wobei der erste Bereich (113) des ersten Substrates (11) außerhalb der ersten Vertiefung (115) angeordnet ist und ein zweiter Bereich (114) des ersten Substrates (11) innerhalb der ersten Vertiefung (115) angeordnet ist, wobei der zweite Bereich (114) des ersten Substrates (11) durch den mindestens einen Graben (15) lateral von anderen Bereichen des ersten Substrates (11) elektrisch isoliert ist,
mindestens ein Teil der aktiven Struktur (252) innerhalb der ersten Vertiefung (115) mit einem Abstand zum ersten Substrat (11) angeordnet ist, und
eine zweite elektrisch leitende Kontaktfläche (18) auf der zweiten Oberfläche (112) des ersten Substrates (11) angeordnet ist, wobei die zweite Kontaktfläche im zweiten Bereich (114) des ersten Substrates (11) angeordnet ist;
**dadurch gekennzeichnet, dass**
der erste Schichtverbund (10) mindestens zwei mit isolierendem Material gefüllte Gräben (15) umfasst,
mindestens zwei zweite Bereiche (114) des ersten Substrates (11) innerhalb der ersten Vertiefung (115) angeordnet sind, und
mindestens zwei zweite Kontaktflächen (18) auf der zweiten Oberfläche (112) des ersten Substrates (11) angeordnet sind, wobei jede zweite Kontaktfläche (18) in einem der zweiten Bereiche (114) des ersten Substrates (11) angeordnet ist.

11. Bauteil (1) nach Anspruch 10,
**dadurch gekennzeichnet, dass**
das Bauteil (1) weiterhin einen dritten Schichtverbund (30) umfasst, der auf der dem ersten Schichtverbund (10) gegenüberliegenden Seite an die Substratschicht (25) angrenzt und ein zweites Substrat (31) umfasst.

12. Bauteil (1) nach Anspruch 11,
**dadurch gekennzeichnet, dass**
der dritte Schichtverbund (30) eine mindestens in einem Bereich leitfähige Deckschicht (35) umfasst, wobei die Deckschicht (35) auf einer ersten Oberfläche (311) des zweiten Substrates (31) angeordnet ist, wobei die erste Oberfläche (311) des zweiten Substrates (31) die der Strukturschicht (25) zugewandte Oberfläche des zweiten Substrates (31) ist,
in einer ersten Oberfläche (351) der Deckschicht (35) eine zweite Vertiefung (352) ausgebildet ist, wobei die erste Oberfläche (351) der Deckschicht (35) die der Strukturschicht (25) zugewandte Oberfläche der Deckschicht (35) ist und wobei die Tiefe der zweiten Vertiefung (352) kleiner als die Dicke der Deckschicht (35) ist, und
der leitfähige Bereich der Deckschicht (35) an den ersten Bereich (251) der Strukturschicht (25) und an einen zweiten Bereich (253) der Strukturschicht (25) angrenzt, wobei der erste Bereich (251) der Strukturschicht (25) außerhalb der aktiven Struktur (252) angeordnet ist und der zweite Bereich (253) der Strukturschicht (25) innerhalb der aktiven Struktur (252) angeordnet und elektrisch leitfähig ist, und die zweite Vertiefung (352) und mindestens ein Teil der aktiven Struktur (252) so angeordnet sind, dass die laterale Position der zweiten Vertiefung (352) der lateralen Position des mindestens einen Teils der aktiven Struktur (252) entspricht, wobei die Deckschicht (35) eine Leiterbahnbrücke (353) bildet, die den zweiten Bereich (253) der Strukturschicht (25) mit dem ersten Bereich (251) der Strukturschicht (25) verbindet.

13. Bauteil (1) nach einem der Ansprüche 11 oder 12,
**dadurch gekennzeichnet, dass**
die Strukturschicht (25) und die der Strukturschicht (25) zugewandte Schicht des dritten Schichtverbundes (30) aus dem selben Material bestehen.

14. Bauteil (1) nach einem der Ansprüche 10 bis 13,
**dadurch gekennzeichnet, dass**
das erste Substrat (11) und die Strukturschicht (25) aus dem selben Material bestehen.

## Claims

1. A method for producing a component (1), comprising:
creating a first layer composite (10), which comprises a first substrate (11) made of an electrically conductive material and at least one trench (15) filled with an insulating material, which extends from a first surface (111) of the first substrate (11), wherein a first region (113) of the first substrate (11) is electrically insulated laterally from other regions of the first substrate (11) by the at least one trench (15) on the first surface (111),
creating a second layer composite (20), which comprises the first layer composite (10) and a structure layer (25), which comprises an active structure (252) of the component and which is electrically conductive at least in a first region (251), wherein the first region (251) of the structure layer (25) adjoins the first surface (111) of the first substrate (11) in the first region (113) of the first substrate (11), and is connected thereto in an electrically conductive manner, and
creating a first electrically conductive contact face (17) on a second surface (112) of the first substrate (11), wherein the second surface (112) is located opposite the first surface (111), and wherein the first contact face (17) is arranged in the first region (113) of the first substrate (11), wherein the first region (113) of the first substrate (11) is electrically insulated laterally from other regions of the first substrate (11) by the at least one trench (15) on the second surface (112), wherein
during creating the first layer composite (10), a first depression (115) is created in the first surface (111) of the first substrate (11), wherein the first depression (115) has a depth smaller than the thickness of the first substrate (11), and wherein the first region (113) of the first substrate (11) is located outside of the first depression (115), and a second region (114) of the first substrate (11) is arranged within the first depression (115), wherein the second region (114) of the first substrate (11) is electrically insulated laterally from other regions of the first substrate (11) by the at least one trench (15) on the first surface (111) of the first substrate (11), and wherein
during creating the second layer composite (20), at least a part of the active structure (252) is arranged within the first depression (115) at a distance to the first substrate (11), and
a second electrically conductive contact face (18) is created on the second surface (112) of the first substrate (11), wherein the second contact face is arranged in the second region (114) of the first substrate (11), and wherein the second region (114) of the first substrate (11) is electrically insulated laterally from other regions of the first substrate (11) by the at least one trench (15) on the second surface (112),
**characterized in that**
the first layer composite (10) comprises at least two trenches (15) filled with insulating material,
at least two second regions (114) of the first substrate (11) are arranged within the first depression (115), and
at least two second contact faces (18) are created on the second surface (112) of the first substrate (11), wherein each of the second contact faces (18) is arranged in one of the second regions (114) of the first substrate (11).

2. The method for producing a component (1) according to claim 1,
**characterized in that**
the first layer composite (10) only comprises the first substrate (11) and the at least one trench (15), and
the at least one trench (15) in the first substrate (11) extends to the second surface (112) of the first substrate (11) prior to creating the second layer composite (20).

3. The method for producing a component (1) according to any one of the claims 1 and 2, **characterized in that**
the at least one trench (15) in the first layer composite (10) extends to a depth, which is smaller than the thickness of the first layer composite (10), prior to creating the second layer composite (20), and,
prior to creating the first contact face (17), the thickness of the first layer composite (10) is reduced from a first surface (12) of the first layer composite (10) to the depth of the at least one trench (15), wherein the first surface (12) of the first layer composite (10) is the surface of the first layer composite (10), which is located opposite to the first surface (111) of the first substrate (11).

4. The method for producing a component (1) according to any one of the preceding claims,
**characterized in that**
the second layer composite (20) further comprises a third layer composite (30) adjoining the substrate layer (25) on the side opposite to the first layer composite (10) and comprising a second substrate (31).

5. The method for producing a component (1) according to claim 4,
**characterized in that**
creating the second layer composite (20) comprises:
creating the structure layer (25) on the first surface (111) of the first substrate (11), and
connecting the structure layer (25) applied to the first layer composite (10) to the third layer composite (30).

6. The method for producing a component (1) according to claim 4,
**characterized in that**
creating the second layer composite (20) comprises:
creating the structure layer (25) on the third layer composite (30), and
connecting the structure layer (25) applied to the third layer composite (30) to the first layer composite (10).

7. The method for producing a component (1) according to any one of the claims 4 to 6,
**characterized in that**
the third layer composite (30) comprises a cover layer (35) conductive at least in a region, wherein the cover layer (35) is arranged on a first surface (311) of the second substrate, wherein the first surface (311) of the second substrate (31) is the surface of the second substrate (31) facing the structure layer (25),
a second depression (352) is created in a first surface (351) of the cover layer (35), wherein the first surface (351) of the cover layer (35) is the surface of the cover layer (35) facing the structure layer (25), and wherein the depth of the second depression (352) is smaller than the thickness of the cover layer (35), and
during creating the second layer composite (20), the conductive region of the cover layer (35) adjoins the first region (251) of the structure layer (25) and a second region (253) of the structure layer (25), wherein the first region (251) of the structure layer (25) is arranged outside of the active structure (252), and the second region (253) of the structure layer (25) is arranged within the active structure (252) and is electrically conductive, and the second depression (352) and at least one part of the active structure (252) are arranged such that the lateral position of the second depression (352) corresponds to the lateral position of the at least one part of the active structure (252), wherein the cover layer (35) forms a conductor path bridge (353), which connects the second region (253) of the structure layer (25) to the first region (251) of the structure layer (25).

8. The method for producing a component (1) according to any one of the claims 4 to 7,
**characterized in that**
the structure layer (25) and the layer of the third layer composite (30) facing the structure layer (25) consist of the same material.

9. The method for producing a component (1) according to any one of the preceding claims,
**characterized in that**
the first substrate (11) and the structure layer (25) consist of the same material.

10. A component (1) comprising:
a first layer composite (10), which comprises a first substrate (11) made of an electrically conductive material and at least one trench (15) filled with an insulating material, which extends from a first surface (111) of the first substrate (11) to a second surface (112) of the first substrate (11), wherein the second surface (112) is located opposite the first surface (111), and wherein a first region (113) of the first substrate (11) is electrically insulated laterally from other regions of the first substrate (11) by the at least one trench (15),
a structure layer (25), which comprises an active structure (252) of the component (1) and which is electrically conductive at least in a first region (251), wherein the first region (251) of the structure layer (25) adjoins the first surface (111) of the first substrate (11) in the first region (113) of the first substrate (11), and is connected to the first region (113) of the first substrate (11) in an electrically conductive manner, and
an electrically conductive contact face (17) is arranged on the second surface (112) of the first substrate (11), wherein the first contact face (17) is arranged in the first region (113) of the first substrate (11), wherein
a first depression (115) is formed in the first surface (111) of the first substrate (11), wherein the first depression (115) has a depth smaller than the thickness of the first substrate (11), and wherein the first region (113) of the first substrate (11) is arranged outside of the first depression (115), and a second region (114) of the first substrate (11) is arranged within the first depression (115), wherein the second region (114) of the first substrate (11) is electrically insulated laterally from other regions of the first substrate (11) by the at least one trench (15),
at least a part of the active structure (252) is arranged within the first depression (115) at a distance to the first substrate (11), and
a second electrically conductive contact face (18) is arranged on the second surface (112) of the first substrate (11), wherein the second contact face is arranged in the second region (114) of the first substrate (11),
**characterized in that**
the first layer composite (10) comprises at least two trenches (15) filled with insulating material,
at least two second regions (114) of the first substrate (11) are arranged within the first depression (115), and
at least two second contact faces (18) are arranged on the second surface (112) of the first substrate (11), wherein each of the second contact faces (18) is arranged in one of the second regions (114) of the first substrate (11).

11. The component (1) according to claim 10,
**characterized in that**
the component (1) further comprises a third layer composite (30) adjoining the substrate layer (25) on the side opposite to the first layer composite (10) and comprising a second substrate (31).

12. The component (1) according to claim 11,
**characterized in that**
the third layer composite (30) comprises a cover layer (35) conductive at least in a region, wherein the cover layer (35) is arranged on a first surface (311) of the second substrate, wherein the first surface (311) of the second substrate (31) is the surface of the second substrate (31) facing the structure layer (25),
a second depression (352) is formed in a first surface (351) of the cover layer (35), wherein the first surface (351) of the cover layer (35) is the surface of the cover layer (35) facing the structure layer (25), and wherein the depth of the second depression (352) is smaller than the thickness of the cover layer (35), and
the conductive region of the cover layer (35) adjoins the first region (251) of the structure layer (25) and a second region (253) of the structure layer (25), wherein the first region (251) of the structure layer (25) is arranged outside of the active structure (252), and the second region (253) of the structure layer (25) is arranged within the active structure (252) and is electrically conductive, and the second depression (352) and at least one part of the active structure (252) are arranged such that the lateral position of the second depression (352) corresponds to the lateral position of the at least one part of the active structure (252), wherein the cover layer (35) forms a conductor path bridge (353), which connects the second region (253) of the structure layer (25) to the first region (251) of the structure layer (25).

13. The component (1) according to any one of claims 11 or 12,
**characterized in that**
the structure layer (25) and the layer of the third layer composite (30) facing the structure layer (25) consist of the same material.

14. The component (1) according to any one of claims 10 to 13,
**characterized in that**
the first substrate (11) and the structure layer (25) consist of the same material.

## Revendications

1. Procédé servant à fabriquer une pièce (1), comprenant :
la production d'un premier composite stratifié (10), qui comprend un premier substrat (11) composé d'un matériau électroconducteur et au moins une tranchée (15) remplie d'un matériau isolant, qui s'étend depuis une première surface (111) du premier substrat (11), dans lequel une première zone (113) du premier substrat (11) est isolée de manière électrique latéralement des autres zones du premier substrat (11) par l'au moins une tranchée (15) au niveau de la première surface (111),
la production d'un deuxième composite stratifié (20), qui comprend le premier composite stratifié (10) et une couche structurelle (25), qui comprend une structure (252) active de la pièce et qui est électroconductrice au moins dans une première zone (251), dans lequel la première zone (251) de la couche structurelle (25) jouxte, dans la première zone (113) du premier substrat (11), la première surface (111) du premier substrat (11) et est reliée à ce dernier de manière électroconductrice, et
la production d'une première surface de contact (17) électroconductrice sur une deuxième surface (112) du premier substrat (11), dans lequel la deuxième surface (112) fait face à la première surface (111) et dans lequel la première surface de contact (17) est disposée dans la première zone (113) du premier substrat (11), dans lequel la première zone (113) du premier substrat (11) est isolée électriquement latéralement d'autres zones du premier substrat (11) par l'au moins une tranchée (15) au niveau de la deuxième surface (112), dans lequel
un premier renfoncement (115) est produit dans la première surface (111) du premier substrat (11) lors de la production du premier composite stratifié (10), dans lequel le premier renfoncement (115) présente une profondeur inférieure à l'épaisseur du premier substrat (11) et dans lequel la première zone (113) du premier substrat (11) est disposée à l'extérieur du premier renfoncement (115) et une deuxième zone (114) du premier substrat (11) est disposée à l'intérieur du premier renfoncement (115), dans lequel la deuxième zone (114) du premier substrat (11) est isolée électriquement latéralement d'autres zones du premier substrat (11) par l'au moins une tranchée (15) au niveau de la première surface (111) du premier substrat (11), et dans lequel
au moins une partie de la structure (252) active est disposée, lors de la production du deuxième composite stratifié (20), à l'intérieur du premier renfoncement (115) à une distance donnée par rapport au premier substrat (11), et
une deuxième surface de contact (18) électroconductrice est produite sur la deuxième surface (112) du premier substrat (11), dans lequel la deuxième surface de contact est disposée dans la deuxième zone (114) du premier substrat (11) et dans lequel la deuxième zone (114) du premier substrat (11) est isolée électriquement latéralement des autres zones du premier substrat (11) par l'au moins une tranchée (15) au niveau de la deuxième surface (112),
**caractérisé en ce que**
le premier composite stratifié (10) comprend au moins deux tranchées (15) remplies d'un matériau isolant,
au moins deux deuxièmes zones (114) du premier substrat (11) sont disposées à l'intérieur du premier renfoncement (115), et
au moins deux deuxièmes surfaces de contact (18) sont produites sur la deuxième surface (112) du premier substrat (11), dans lequel chaque deuxième surface de contact (18) est disposée dans une des deuxièmes zones (114) du premier substrat (11).

2. Procédé servant à fabriquer une pièce (1) selon la revendication 1,
**caractérisé en ce que**
le premier composite stratifié (10) ne comprend que le premier substrat (11) et l'au moins une tranchée (15), et
l'au moins une tranchée (15) s'étend dans le premier substrat (11) avant la production du deuxième composite stratifié (20) jusqu'à la deuxième surface (112) du premier substrat (11).

3. Procédé servant à fabriquer une pièce (1) selon l'une quelconque des revendications 1 et 2,
**caractérisé en ce que**
l'au moins une tranchée (15) s'étend dans le premier composite stratifié (10) avant la production du deuxième composite stratifié (20) jusqu'à une profondeur donnée, qui est inférieure à l'épaisseur du premier composite stratifié (10), et
l'épaisseur du premier composite stratifié (10) est réduite, avant la production de la première surface de contact (17), en partant d'une première surface (12) du premier composite stratifié (10) jusqu'à la profondeur de l'au moins une tranchée (15), dans lequel la première surface (12) du premier composite stratifié (10) est la surface du premier composite stratifié (10), qui fait face à la première surface (111) du premier substrat (11).

4. Procédé servant à fabriquer une pièce (1) selon l'une quelconque des revendications précédentes,
**caractérisé en ce que**
le deuxième composite stratifié (20) comprend par ailleurs un troisième composite stratifié (30), qui jouxte, sur le côté faisant face au premier composite stratifié (10), la couche de substrat (25) et qui comprend un deuxième substrat (31).

5. Procédé servant à fabriquer une pièce (1) selon la revendication 4,
**caractérisé en ce que**
la production du deuxième composite stratifié (20) comprend :
la production de la couche structurelle (25) sur la première surface (111) du premier substrat (11), et
la liaison de la couche structurelle (25) appliquée sur le premier composite stratifié (10) au troisième composite stratifié (30).

6. Procédé servant à fabriquer une pièce (1) selon la revendication 4,
**caractérisé en ce que**
la production du deuxième composite stratifié (20) comprend :
la production de la couche structurelle (25) sur le troisième composite stratifié (30), et
la liaison de la couche structurelle (25) appliquée sur le troisième composite stratifié (30) au premier composite stratifié (10).

7. Procédé servant à fabriquer une pièce (1) selon l'une quelconque des revendications 4 à 6,
**caractérisé en ce que**
le troisième composite stratifié (30) comprend une couche couvrante (35) conductrice au moins dans une zone, dans lequel la couche couvrante (35) est disposée sur une première surface (311) du deuxième substrat (31), dans lequel la première surface (311) du deuxième substrat (31) est la surface, tournée vers la couche structurelle (25), du deuxième substrat (31),
un deuxième renfoncement (352) est produit dans une première surface (351) de la couche couvrante (35), dans lequel la première surface (351) de la couche couvrante (35) est la surface, tournée vers la couche structurelle (25), de la couche couvrante (35) et dans lequel la profondeur du deuxième renfoncement (352) est inférieure à l'épaisseur de la couche couvrante (35), et
la zone conductrice de la couche couvrante (35) est disposée, lors de la production du deuxième composite stratifié (20), au niveau de la première zone (251) de la couche structurelle (25) et de manière adjacente à une deuxième zone (253) de la couche structurelle (25), dans lequel la première zone (251) de la couche structurelle (25) est disposée à l'extérieur de la structure (252) active et la deuxième zone (253) de la couche structurelle (25) est disposée à l'intérieur de la structure (252) active et est électroconductrice, et le deuxième renfoncement (352) et au moins une partie de la structure (252) active sont disposés de telle sorte que la position latérale du deuxième renfoncement (352) correspond à la position latérale de l'au moins une partie de la structure (252) active, dans lequel la couche couvrante (35) forme un pont de bande conductrice (353), qui relie la deuxième zone (253) de la couche structurelle (25) à la première zone (251) de la couche structurelle (25).

8. Procédé servant à fabriquer une pièce (1) selon l'une quelconque des revendications 4 à 7,
**caractérisé en ce que**
la couche structurelle (25) et la couche, tournée vers la couche structurelle (25), du troisième composite stratifié (30) sont constituées du même matériau.

9. Procédé servant à fabriquer une pièce (1) selon l'une quelconque des revendications précédentes,
**caractérisé en ce que**
le premier substrat (11) et la couche structurelle (25) sont constitués du même matériau.

10. Pièce (1) comprenant :
un premier composite stratifié (10), qui comprend un premier substrat (11) composé d'un matériau électroconducteur et au moins une tranchée (15) remplie d'un matériau isolant, laquelle tranchée s'étend depuis une première surface (111) du premier substrat (11) jusqu'à une deuxième surface (112) du premier substrat (11), dans laquelle la deuxième surface (112) fait face à la première surface (111) et dans laquelle une première zone (113) du premier substrat (11) est isolée électriquement latéralement d'autres zones du premier substrat (11) par l'au moins une tranchée (15),
une couche structurelle (25), qui comprend une structure (252) active de la pièce (1) et qui est, au moins dans une première zone (251), électroconductrice, dans laquelle la première zone (251) de la couche structurelle (25) jouxte, dans la première zone (113) du premier substrat (11), la première surface (111) du premier substrat (11) et est reliée de manière électroconductrice à la première zone (113) du premier substrat (11), et
une surface de contact (17) électroconductrice sur la deuxième surface (112) du premier substrat (11), dans laquelle la première surface de contact (17) est disposée dans la première zone (113) du premier substrat (11), dans laquelle
un premier renfoncement (115) est réalisé dans la première surface (111) du premier substrat (11), dans laquelle le premier renfoncement (115) présente une épaisseur inférieure à l'épaisseur du premier substrat (11) et dans laquelle la première zone (113) du premier substrat (11) est disposée à l'extérieur du premier renfoncement (115) et une deuxième zone (114) du premier substrat (11) est disposée à l'intérieur du premier renfoncement (115), dans laquelle la deuxième zone (114) du premier substrat (11) est isolée électriquement latéralement d'autres zones du premier substrat (11) par l'au moins une tranchée (15),
au moins une partie de la structure (252) active est disposée à l'intérieur du premier renfoncement (115) à une distance donnée par rapport au premier substrat (11), et
une deuxième surface de contact (18) électroconductrice sur la deuxième surface (112) du premier substrat (11), dans laquelle la deuxième surface de contact est disposée dans la deuxième zone (114) du premier substrat (11),
**caractérisée en ce que**
le premier composite stratifié (10) comprend au moins deux tranchées (15) remplies d'un matériau isolant,
au moins deux deuxièmes zones (114) du premier substrat (11) sont disposées à l'intérieur du premier renfoncement (115), et
au moins deux deuxièmes surfaces de contact (18) sont disposées sur la deuxième surface (112) du premier substrat (11), dans laquelle chaque deuxième surface de contact (18) est disposée dans une des deuxièmes zones (114) du premier substrat (11).

11. Pièce (1) selon la revendication 10,
**caractérisée en ce que**
la pièce (1) comprend par ailleurs un troisième composite stratifié (30), qui jouxte, sur le côté faisant face au premier composite stratifié (10), la couche de substrat (25) et qui comprend un deuxième substrat (31).

12. Pièce (1) selon la revendication 11,
**caractérisée en ce que**
le troisième composite stratifié (30) comprend une couche couvrante (35) conductrice au moins dans une zone, dans laquelle la couche couvrante (35) est disposée sur une première surface (311) du deuxième substrat (31), dans laquelle la première surface (311) du deuxième substrat (31) est la surface, tournée vers la couche structurelle (25), du deuxième substrat (31),
un deuxième renfoncement (352) est réalisé dans une première surface (351) de la couche couvrante (35), dans laquelle la première surface (351) de la couche couvrante (35) est la surface, tournée vers la couche structurelle (25), de la couche couvrante (35) et dans laquelle la profondeur du deuxième renfoncement (352) est inférieure à l'épaisseur de la couche couvrante (35), et
la zone conductrice de la couche couvrante (35) jouxte la première zone (251) de la couche structurelle (25) et une deuxième zone (253) de la couche structurelle (25), dans laquelle la première zone (251) de la couche structurelle (25) est disposée à l'extérieur de la structure (252) active et la deuxième zone (253) de la couche structurelle (25) est disposée à l'intérieur de la structure (252) active et est électroconductrice, et le deuxième renfoncement (352) et au moins une partie de la structure (252) active sont disposés de telle manière que la position latérale du deuxième renfoncement (352) correspond à la position latérale de l'au moins une partie de la structure active (252), dans laquelle la couche couvrante (35) forme un pont de piste conductrice (353), lequel relie la deuxième zone (253) de la couche structurelle (25) à la première zone (251) de la couche structurelle (25).

13. Pièce (1) selon l'une quelconque des revendications 11 ou 12,
**caractérisée en ce que**
la couche structurelle (25) et la couche, tournée vers la couche structurelle (25), du troisième composite stratifié (30) sont constituées du même matériau.

14. Pièce (1) selon l'une quelconque des revendications 10 à 13,
**caractérisée en ce que**
le premier substrat (11) et la couche structurelle (25) sont constitués du même matériau.
